# EUROPEAN PATENT SPECIFICATION

(11) **EP 3 737 051 B1**
(45) Date of publication and mention of the grant of the patent: **18.01.2023**
(21) Application number: 18908681.2
(22) Date of filing: 19.12.2018
(51) Int. Cl.: H04L 25/02

(54) **LINE DRIVE APPARATUS**
ZEILENANTRIEBSVORRICHTUNG
APPAREIL DE PILOTAGE DE LIGNE

(30) Priority: 05.03.2018 CN 201810178433
(43) Date of publication of application: 11.11.2020
(73) Proprietor: HUAWEI TECHNOLOGIES CO., LTD., Shenzhen, Guangdong 518129 (CN)
(72) Inventor: ZHAO, Zhilei, Shenzhen, Guangdong 518129 (CN); LI, Dong, Shenzhen, Guangdong 518129 (CN)
(74) Representative: MERH-IP Matias Erny Reichl Hoffmann Patentanwälte PartG mbB
(86) International application number: PCT/CN2018/122171
(87) International publication number: WO 2019/169929

(56) References cited:
- WO-A1-03/009553
- WO-A1-2011/039063
- CN-A- 102 217 205
- CN-A- 102 687 474
- US-A1- 2007 223 360
- US-A1- 2008 224 769
- US-A1- 2016 294 587

## Description

### TECHNICAL FIELD

This application relates to the field of communications technologies, and in particular, to a line driving apparatus.

### BACKGROUND

An x digital subscriber line (xDSL) communications device (such as a modem) usually includes a digital front end (DFE), an analog front end (AFE), a line driver (LD), and a hybrid circuit. The DFE is configured to perform digital signal processing on a signal that is input by an external device to the DFE, to implement a function of an xDSL protocol. The AFE is configured to perform digital-to-analog conversion on a signal that is input by the DFE to the AFE, and perform analog-to-digital conversion on a signal that is input by the hybrid circuit to the AFE. The LD is configured to perform power amplification on a signal that is input by the AFE to the LD. The hybrid circuit is configured to: separate a signal that is output by the LD from a signal that is input by the external device to the hybrid circuit; couple, to a transmission cable for transmission, the signal that is output by the LD; and send, to the AFE, the signal that is input by the external device to the hybrid circuit.

The line driver is a final-stage power sending unit of the xDSL communications device. A transmit power and performance of the line driver directly determine link quality and a transmission distance of a communications system. An xDSL communications system uses an orthogonal frequency division multiplexing (OFDM) modulation scheme, a relatively large quantity of bits (15 bits) are used to carry data, and a peak-to-average ratio of an output signal of the line driver usually can reach 16 dB (in other words, a peak value of an amplitude of the output signal of the line driver is approximately 6.3 times an effective value of the amplitude of the output signal). Therefore, a power supply source of the line driver needs to be large enough to meet a requirement for amplifying a peak signal of input signals of the line driver, to ensure that the output signal of the line driver is not distorted,

Currently, power is supplied to the line driver mainly by using a charge pump. When an amplitude of the input signal of the line driver is greater than or equal to a specified value, power is supplied to the line driver by using a signal obtained by superimposing a voltage signal that is generated by electric discharge of a capacitor in a charge pump circuit and a voltage signal that is output by a low-voltage power source charging the capacitor. When the input signal of the line driver is less than the specified value, power is supplied to the line driver by using a voltage signal that is output by the low-voltage power source in the charge pump circuit, so that the line driver performs power amplification on the input signal of the line driver based on the voltage signal output by the charge pump circuit.

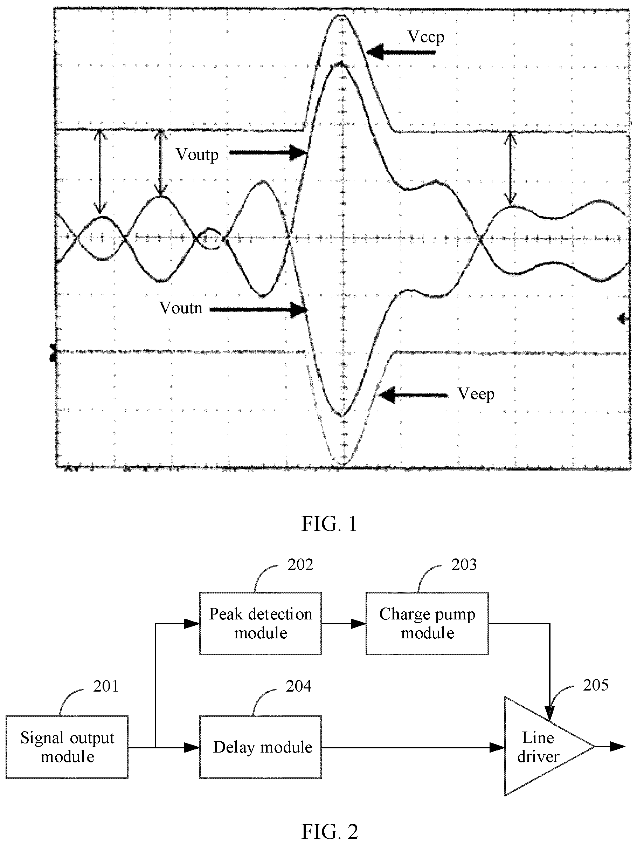

When power is supplied by using the charge pump, a signal output by the line driver and the signal output by the charge pump circuit are shown in FIG. 1. Vₑₑₚ is a positive voltage output by a charge pump module, Vₑₑₚ is a negative voltage output by the charge pump module, and Voutp and Voutn are differential signals output by the line driver. In the OFDM system, a proportion of peak signals is quite small or is 0, and power is supplied to the line driver mostly by the low-voltage power source in the charge pump circuit. In addition, an output voltage of the low-voltage power source in the charge pump circuit cannot be excessively small; otherwise, the requirement for amplifying the peak signal in the input signal of the line driver cannot be met. Consequently, a voltage difference between a power supply voltage and the output signal of the line driver is relatively large in a relatively long time. As a result, the power supply voltage of the line driver is mostly consumed as thermal energy on the line driver, causing relatively high ineffective power consumption of the line driver.
Document US 2016/294587 A1 generally describes a system, apparatus and method for dynamically boosting (increasing) the power supply voltage to an envelope tracking (ET) modulator within a transmitter system when the target/desired power amplifier voltage supply is above a predetermined threshold (e.g., equal to the available power supply of the system, such as a battery).
Document US 2008/224769 A1 generally discloses a circuit for use with a power amplifier that amplifies an input signal, comrising an amplitude correction circuit and an open-loop switching regulator. The amplitude correction circuit may be configured to generate a corrected envelope signal from an input envelope signal that represents an envelope of the input signal. The open-loop switching regulator may be connected to the amplitude correction circuit and may be for powering the power amplifier based on the corrected envelope signal.
Document US 2007/223360 A1 generally relates to a signal output circuit, a communication apparatus and a signal output control method that amplify and output OFDM signals or the like used for power line communication or the like.

### SUMMARY

This application provides a line driving apparatus, to resolve a prior-art problem that ineffective power consumption of a line driver is relatively high because power is supplied to the line driver by using a charge pump. In particular, there is provided a line driving apparatus, having the features of independent claim 1. The dependent claims related to preferred embodiments.

A line driving apparatus provided in this application includes: a signal output module, a first power supply module, a second power supply module, and a line driving module. The first power supply module is connected to the signal output module and a first input end of the line driving module. The second power supply module is connected to the signal output module and the first input end of the line driving module. A second input end of the line driving module is connected to the signal output module.

The signal output module is configured to output a first signal to the first power supply module, output a second signal to the second power supply module, and output a third signal to the line driving module. The first signal is a digital signal or an analog signal of a to-be-processed voltage signal, the second signal is a digital signal or an analog signal of the to-be-processed voltage signal, and the third signal is a digital signal or an analog signal of the to-be-processed voltage signal.

The first power supply module is configured to receive the first signal, generate a corresponding first voltage based on an amplitude of the first signal at each moment, and output the first voltage to the line driving module through the first input end of the line driving module. An amplitude of the first voltage at any moment is greater than an amplitude of the first signal at the moment, and a difference between the amplitude of the first voltage at any moment and the amplitude of the first signal at the moment is within a specified range.

The second power supply module is configured to: receive the second signal; determine whether an absolute value of an amplitude of the second signal is greater than or equal to a specified threshold; if yes, generate a second voltage based on the amplitude of the second signal and output the second voltage to the line driving module through the first input end of the line driving module; otherwise, output no signal, where an amplitude of the second voltage is greater than the amplitude of the second signal.

The line driving module is configured to receive the third signal, and perform power amplification on the third signal based on the first voltage and the second voltage.

By using the foregoing solution, when an absolute value of an amplitude of a signal output by the signal output module is less than the specified threshold, in other words, when the amplitude of the signal output by the signal output module is relatively small, the second power supply module does not output a signal. In this case, the line driving module amplifies, based on the first voltage output by the first power supply module, a signal output by the signal output module. In addition, the amplitude of the first voltage at any moment is greater than an amplitude at the moment of a signal output by the signal output module; and a difference between the amplitude of the first voltage at any moment and the amplitude at the moment of the signal output by the signal output module is within the specified range. To be specific, when the first voltage changes with the signal output by the signal output module causing the absolute value of the amplitude of the signal output by the signal output module to be less than the specified threshold, a difference between an amplitude of a voltage signal output by the line driving module and the amplitude of the first voltage is relatively small. In other words, the line driver can amplify, by effectively using the first voltage, the signal output by the signal output module, thereby reducing heat generated by the line driving module by using the first voltage. When the absolute value of the amplitude of the signal output by the signal output module is greater than or equal to the specified threshold, in other words, when the amplitude of the signal output by the signal output module is relatively large, the second power supply module outputs the second voltage; and the line driving module amplifies, based on the first voltage and the second voltage, the signal output by the signal output module. In this way, when the absolute value of the amplitude of the signal output by the signal output module is greater than or equal to the specified threshold, the first power supply module and the second power supply module can provide the line driving module with voltage signals having relatively large amplitudes, to meet a requirement of the line driving module for amplifying the signal output by the signal output module.

A proportion of signals, among signals output by the signal output module, whose amplitudes have absolute values greater than or equal to the specified threshold is relatively small, and when the absolute value of the amplitude of the signal output by the signal output module is less than the specified threshold, the difference between the amplitude of the voltage signal output by the line driving module and the amplitude of the first voltage is relatively small. Therefore, the line driving apparatus provided in this application can improve utilization, by the line driving module, of the voltages output by the first power supply module and the second power supply module, thereby reducing power consumption and heat dissipation costs of the line driving apparatus.

In a possible implementation, the line driving apparatus further includes an anti-backflow module, which is separately connected to an output end of the first power supply module and the first input end of the line driving module. The anti-backflow module is configured to be conducted when the second signal output by the signal output module is less than the specified threshold, to output, to the first input end of the line driving module, the first voltage output by the first power supply module; and is configured to be terminated when the second signal output by the signal output module is greater than or equal to the specified threshold, to prevent the second voltage output by the second power supply module from backflowing into the first power supply module, so that performance of the first power supply module and the line driving module is not affected.

In a possible implementation, the line driving apparatus may further include a control module. A first input end of the control module is connected to the first power supply module, a second input end of the control module is connected to the second power supply module, and an output end of the control module is connected to the first input end of the line driving module. The control module is configured to compare the amplitude of the first voltage output by the signal output module with the amplitude of the second voltage output by the second power supply module, and output a voltage, with a larger amplitude, of the first voltage and the second voltage.

By using the foregoing solution, when the absolute value of the amplitude of the signal output by the signal output module is less than the specified threshold, the line driving module amplifies, based on the first voltage, the signal output by the signal output module; or when the absolute value of the amplitude of the signal output by the signal output module is greater than or equal to the specified threshold, the line driving module amplifies, based on the second voltage output by the second power supply module, the signal output by the signal output module, to further reduce the power consumption of the line driving apparatus.

In a possible implementation, after receiving the first signal and before generating the corresponding first voltage based on the amplitude of the first signal at each moment, the first power supply module is further configured to: determine whether an absolute value of the amplitude of the first signal is less than the specified threshold; if yes, generate the corresponding first voltage based on the amplitude of the first signal at each moment; otherwise, output no signal.

By using the foregoing solution, when the absolute value of the amplitude of the signal output by the signal output module is less than the specified threshold, the line driving module amplifies, based on the first voltage, the signal output by the signal output module; or when the absolute value of the amplitude of the signal output by the signal output module is greater than or equal to the specified threshold, the line driving module amplifies, based on the second voltage output by the second power supply module, the signal output by the signal output module, to further reduce the power consumption of the line driving apparatus.

In a possible implementation, the first power supply module specifically includes an envelope module and a power source tracking module. The envelope module is configured to receive the first signal, generate an envelope signal of the first signal based on the first signal, and output the envelope signal of the first signal to the power source tracking module. The power source tracking module is configured to receive the envelope signal of the first signal, generate the first voltage based on the envelope signal of the first signal, and output the first voltage through the first input end of the line driving module.

In a possible implementation, before outputting the envelope signal of the first signal to the power source tracking module, the envelope module may further be configured to perform smooth filtering on the envelope signal of the first signal, to remove some high frequency components from the envelope signal of the first signal, so that the power source tracking module can output the first voltage accurately following a change of an envelope signal obtained after the smooth filtering.

In a possible implementation, when the first signal is a digital signal, the power source tracking module specifically includes a pulse width modulation module and a signal generation module. A first input end of the pulse width modulation module is connected to an output end of the envelope module, and an output end of the pulse width modulation module is connected to an input end of the signal generation module.

The pulse width modulation module is configured to: receive the envelope signal of the first signal; generate, based on the envelope signal of the first signal, a pulse width modulation signal corresponding to the envelope signal; and output the pulse width modulation signal corresponding to the envelope signal to the signal generation module. The signal generation module is configured to receive the pulse width modulation signal, generate the first voltage based on the pulse width modulation signal, and output the first voltage through the first input end of the line driving module.

In a possible implementation, the power source tracking module further includes an analog-to-digital conversion module, configured to receive the first voltage, convert the first voltage into a digital signal, and feed back the digital signal of the first voltage to the pulse width modulation module. The pulse width modulation module is further configured to receive the digital signal of the first voltage, compare the envelope signal of the first signal with the digital signal of the first voltage, and adjust the pulse width modulation signal based on a result of the comparison. In this way, the first voltage can accurately follow a change of the first signal.

In a possible implementation, the second power supply module specifically includes a peak detection module and a charge pump module. The peak detection module is configured to: receive the second signal; determine whether the absolute value of the amplitude of the second signal is greater than or equal to the specified threshold; if yes, output a first control signal; otherwise, output a second control signal, where the first control signal is used to control the charge pump module to generate and output the second voltage, and the second control signal is used to control the charge pump module not to output a signal. The charge pump module is configured to: when the absolute value of the amplitude of the second signal is greater than or equal to the specified threshold, receive the first control signal, and generate and output the second voltage based on the first control signal; and when the absolute value of the amplitude of the second signal is less than the specified threshold, receive the second control signal and output no signal.

In a possible implementation, when the third signal is an analog signal, the line driving module is a line driver.

In a possible implementation, when the third signal is a digital signal, the line driving module includes a digital-to-analog conversion module and a line driver. A first input end of the line driver is separately connected to the first power supply module and the second power supply module. The digital-to-analog conversion module is separately connected to the signal output module and a second input end of the line driver.

The digital-to-analog conversion module is configured to receive the third signal, convert the third signal into an analog signal, and output the analog signal of the third signal to the line driver through the second input end of the line driver. The line driver is configured to receive the analog signal of the third signal, and perform power amplification on the analog signal of the third signal based on the first voltage and the second voltage.

In a possible implementation, the first voltage, the second voltage, and the third signal are synchronous. This prevents distortion of the signal output by the line driving module caused because a voltage obtained by superimposing the first voltage and the second voltage at a specific moment cannot meet a requirement for amplifying the third signal at the moment when the line driving module amplifies the third signal based on the first voltage and the second voltage.

In a possible implementation, after receiving the first signal and before outputting the first voltage, the first power supply module is further configured to perform delay processing on the first voltage.

In a possible implementation, after receiving the second signal, the second power supply module is further configured to perform delay processing on the second signal.

In a possible implementation, after receiving the third signal and before performing power amplification on the third signal based on the first voltage and the second voltage, the line driving module is further configured to perform delay processing on the third signal.

According to an example, this application provides a line driving method, where the method is applied to a power supply module. The power supply module has the functions of the first power supply module and the second power supply module according to the first aspect. The method includes:
receiving a first signal sent by a signal output module, and generating a corresponding first voltage based on an amplitude of the first signal at each moment, where the first signal is a digital signal or an analog signal of a to-be-processed voltage signal, and an amplitude of the first voltage at any moment is greater than an amplitude of the first signal at the moment, and a difference between the amplitude of the first voltage at any moment and the amplitude of the first signal at the moment is within a specified range;
receiving a second signal sent by the signal output module; determining whether an absolute value of an amplitude of the second signal is greater than or equal to a specified threshold; if yes, generating a second voltage based on the amplitude of the second signal, and outputting the first voltage and the second voltage to the line driving module through a first input end of the line driving module; otherwise, outputting the first voltage to the line driving module through the first input end of the line driving module, where the second signal is a digital signal or an analog signal of the to-be-processed voltage signal, and an amplitude of the second voltage is greater than the amplitude of the second signal, so that the line driving module performs power amplification on a third signal based on the first voltage and the second voltage, where the third signal is a digital signal or an analog signal that is of the to-be-processed voltage signal and that is output by the signal output module to a second input end of the line driving module.

By using the foregoing solution, when an absolute value of an amplitude of a signal output by the signal output module is less than the specified threshold, in other words, when the amplitude of the signal output by the signal output module is relatively small, the line driving module amplifies, based on the first voltage, a signal output by the signal output module. In addition, the amplitude of the first voltage at any moment is greater than an amplitude at the moment of a signal output by the signal output module; and a difference between the amplitude of the first voltage at any moment and the amplitude at the moment of the signal output by the signal output module is within the specified range. To be specific, when the first voltage changes with the signal output by the signal output module causing the absolute value of the amplitude of the signal output by the signal output module to be less than the specified threshold, a difference between an amplitude of a voltage signal output by the line driving module and the amplitude of the first voltage is relatively small. In other words, the line driver can amplify, by effectively using the first voltage, the signal output by the signal output module, thereby reducing heat generated by the line driving module by using the first voltage. When the absolute value of the amplitude of the signal output by the signal output module is greater than or equal to the specified threshold, in other words, when the amplitude of the signal output by the signal output module is relatively large, the line driving module amplifies, based on the first voltage and the second voltage, the signal output by the signal output module. In this way, when the absolute value of the amplitude of the signal output by the signal output module is greater than or equal to the specified threshold, voltage signals having relatively large amplitudes can be provided to the line driving module, to meet a requirement of the line driving module for amplifying the signal output by the signal output module.

A proportion of signals, among signals output by the signal output module, whose amplitudes have absolute values greater than or equal to the specified threshold is relatively small, and when the absolute value of the amplitude of the signal output by the signal output module is less than the specified threshold, the difference between the amplitude of the voltage signal output by the line driving module and the amplitude of the first voltage is relatively small. Therefore, the line driving method provided in this application can improve utilization of a power supply voltage by the line driving module, thereby reducing power consumption and heat dissipation costs of a line driving apparatus.

In a possible implementation, after the receiving a first signal and before the generating a corresponding first voltage based on an amplitude of the first signal at each moment, the method further includes: determining whether an absolute value of the amplitude of the first signal is less than the specified threshold; if yes, generating the corresponding first voltage based on the amplitude of the first signal at each moment; otherwise, generating the second voltage based on the amplitude of the second signal.

By using the foregoing solution, when the absolute value of the amplitude of the signal output by the signal output module is less than the specified threshold, the line driving module amplifies, based on the first voltage, the signal output by the signal output module; or when the absolute value of the amplitude of the signal output by the signal output module is greater than or equal to the specified threshold, the line driving module amplifies, based on the second voltage, the signal output by the signal output module, to further reduce the power consumption of the line driving apparatus.

In a possible implementation, the generating a corresponding first voltage based on an amplitude of the first signal at each moment specifically includes the following steps: generating an envelope signal of the first signal based on the first signal, and generating the first voltage based on the envelope signal of the first signal.

In a possible implementation, after the generating an envelope signal of the first signal based on the first signal and before the generating the first voltage based on the envelope signal of the first signal, the method may further include: performing smooth filtering on the envelope signal of the first signal, to remove some high frequency components from the envelope signal of the first signal.

In a possible implementation, when the first signal is a digital signal, the generating the first voltage based on the envelope signal of the first signal includes the following steps: generating, based on the envelope signal of the first signal, a pulse width modulation signal corresponding to the envelope signal; and generating the first voltage based on the pulse width modulation signal.

In a possible implementation, when the first signal is a digital signal, after the generating the first voltage based on the pulse width modulation signal, the method further includes: converting the first voltage into a digital signal, comparing the envelope signal of the first signal and the digital signal of the first voltage, and adjusting the pulse width modulation signal based on a result of the comparison. In this way, the first voltage can accurately follow a change of the first signal.

In a possible implementation, when the third signal is an analog signal, the line driving module is a line driver.

In a possible implementation, the first voltage, the second voltage, and the third signal are synchronous. This prevents distortion of the signal output by the line driving module caused because a voltage obtained by superimposing the first voltage and the second voltage at a specific moment cannot meet a requirement for amplifying the third signal at the moment when the line driving module amplifies the third signal based on the first voltage and the second voltage.

In a possible implementation, after the receiving a first signal and before the outputting the first voltage, the method further includes: performing delay processing on the first voltage.

In a possible implementation, after the receiving a second signal and before the outputting the second voltage, the method further includes: performing delay processing on the second signal.

In summary, this application provides the line driving apparatus and method. By using the solutions provided in this application, utilization of a power supply voltage by the line driving module can be improved, thereby reducing the power consumption and heat dissipation costs of the line driving apparatus.

### BRIEF DESCRIPTION OF DRAWINGS

FIG. 1 is a schematic diagram of an output signal of a line driver and a power supply voltage signal of the line driver in the prior art;
FIG. 2 is a schematic diagram of a structure of a line driving apparatus in the prior art;
FIG. 3 is a schematic diagram of a structure of a line driving apparatus according to an embodiment of this application;
FIG. 4a is a schematic diagram of a structure of a line driving apparatus according to an embodiment of this application;
FIG. 4b is a schematic diagram of a structure of a line driving apparatus according to an embodiment of this application;
FIG. 5 is a schematic diagram of a structure of a first power supply module according to an embodiment of this application;
FIG. 6 is a schematic diagram of an envelope signal according to an embodiment of this application;
FIG. 7 is a schematic diagram of a structure of a power source tracking module according to an embodiment of this application;
FIG. 8 is a schematic diagram of a structure of another power source tracking module according to an embodiment of this application;
FIG. 9 is a schematic diagram of a structure of a second power supply module according to an embodiment of this application;
FIG. 10 is a schematic diagram of a structure of a charge pump module according to an embodiment of this application;
FIG. 11 is a schematic diagram of an output signal of a line driving module and a power supply voltage signal of the line driving module according to an embodiment of this application;
FIG. 12a is a schematic diagram of a structure of a line driving module according to an embodiment of this application;
FIG. 12b is a schematic diagram of a structure of another line driving module according to an embodiment of this application;
FIG. 13a is a schematic diagram of a structure of a line driving apparatus according to an embodiment of this application;
FIG. 13b is a schematic diagram of a structure of a line driving apparatus according to an embodiment of this application;
FIG. 13c is a schematic diagram of a structure of a line driving apparatus according to an embodiment of this application;
FIG. 13d is a schematic diagram of a structure of a line driving apparatus according to an embodiment of this application; and
FIG. 14 is a schematic flowchart of a line driving method according to an embodiment of this application.

### DESCRIPTION OF EMBODIMENTS

FIG. 2 shows a structure of a line driving apparatus 200 in the prior art. The line driving apparatus 200 includes a signal output module 201, a peak detection module 202, a charge pump module 203, a delay module 204, and a line driver 205. An input end of the peak detection module 202 is connected to an output end of the signal output module 201, an output end of the peak detection module 202 is connected to an input end of the charge pump module 203, an output end of the charge pump module 203 is connected to an input end of the line driver 205, an input end of the delay module 204 is connected to the output end of the signal output module 201, and an output end of the delay module 204 is connected to another input end of the line driver 205.

The signal output module 201 is configured to output a to-be-amplified signal to the peak detection module 202 and the delay module 204. If the line driving module 200 is disposed in an xDSL communications device, the signal output module 201 may be an AFE.

The peak detection module 202 is configured to: receive the to-be-amplified signal output by the signal output module 201; detect an amplitude of the to-be-amplified signal; determine whether an absolute value of the amplitude of the to-be-amplified signal is greater than a specified value; if yes, output a first control signal, to control a capacitor in the charge pump module 203 to discharge, so that the charge pump module 203 supplies power to the line driver 205 by using a voltage signal obtained by superimposing a voltage signal that is generated through the discharging by the capacitor and a voltage signal that is output by a low-voltage power source charging the capacitor in the charge pump module 203; otherwise, output a second control signal, to control the low-voltage power source in the charge pump module 203 to charge the capacitor in the charge pump module 203 and control the charge pump module 203 to supply power to the line driver 205 by using the low-voltage power source.

The charge pump module 203 is configured to receive the first control signal sent by the peak detection module 202, and supply power to the line driver 205 based on the first control signal by outputting the voltage signal obtained by superimposing the voltage signal that is generated through the discharging by the capacitor in the charge pump module 203 and the voltage signal that is output by the low-voltage power source in the charge pump module 203; or receive the second control signal sent by the peak detection module 202, and based on the second control signal, charge the capacitor in the charge pump module 203 by using the low-voltage power source in the charge pump module 203 and supply power to the line driver 205 by using a voltage signal output by the low-voltage power source.

The delay module 204 is configured to perform delay processing on the to-be-amplified signal output by the signal output module 201, to keep a signal output by the delay module 204 synchronous with a voltage signal output by the charge pump module 203.

The line driver 205 is configured to perform power amplification, based on the voltage signal output by the charge pump module 203, on the signal output by the delay module 204.

A proportion of signals, among to-be-amplified signals output by the signal output module 201, whose amplitudes have absolute values greater than the specified value is relatively small. Therefore, power is supplied to the line driver mostly by the low-voltage power source in the charge pump module. In addition, an output voltage of the low-voltage power source in the charge pump module 203 cannot be excessively small; otherwise, a requirement of the line driver 205 for amplifying a signal, among signals output by the delay module 204, whose amplitude has an absolute value greater than the specified value cannot be met. Consequently, a voltage difference between a power supply voltage of the line driver 205 and the signal output by the line driver 205 is relatively large in a relatively long time (as shown in FIG. 1). As a result, the power supply voltage of the line driver 205 is mostly consumed as thermal energy on the line driver, causing relatively high ineffective power consumption of the line driver 205.

To resolve a prior-art problem of relatively high ineffective power consumption of a line driver, this application provides a line driving apparatus and method, to improve driving efficiency of a line driver and reduce ineffective power consumption.

It should be noted that in the descriptions of the embodiments of this application, terms such as "first" and "second" are merely intended for distinction in description, but should not be construed as indicating or implying relative importance or indicating or implying a sequence.

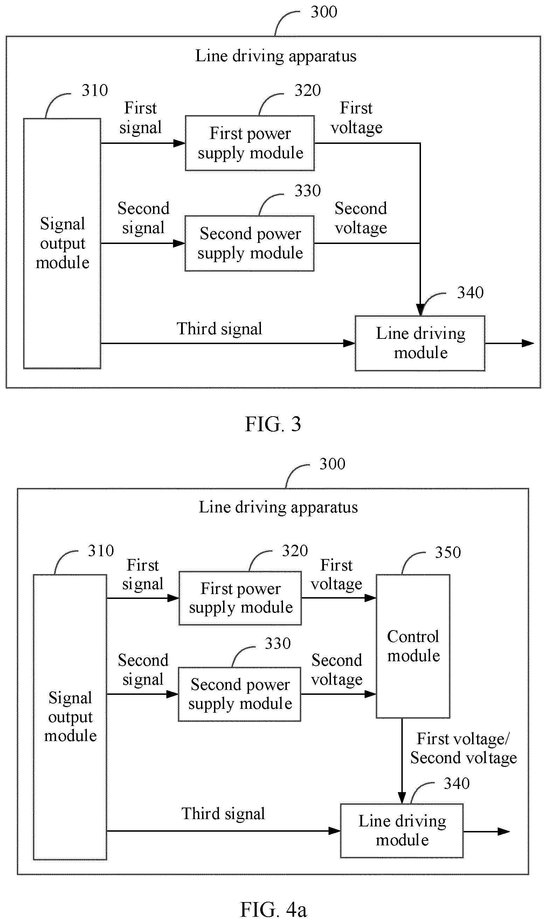

As shown in FIG. 3, a line driving apparatus 300 provided in an embodiment of this application includes a signal output module 310, a first power supply module 320, a second power supply module 330, and a line driving module 340. The first power supply module 320 is connected to the signal output module 310 and a first input end of the line driving module 340. The second power supply module 330 is connected to the signal output module 310 and the first input end of the line driving module 340. A second input end of the line driving module 340 is connected to the signal output module 310.

The signal output module 310 is configured to output a first signal to the first power supply module 320, output a second signal to the second power supply module 330, and output a third signal to the line driving module 340. The first signal is a digital signal or an analog signal of a to-be-processed voltage signal, the second signal is a digital signal or an analog signal of the to-be-processed voltage signal, and the third signal is a digital signal or an analog signal of the to-be-processed voltage signal.

The first power supply module 320 is configured to receive the first signal output by the signal output module 310, generate a corresponding first voltage based on an amplitude of the first signal at each moment, and output the first voltage to the line driving module 340 through the first input end of the line driving module 340. An amplitude of the first voltage at any moment is greater than an amplitude of the first signal at the moment, and a difference between the amplitude of the first voltage at any moment and the amplitude of the first signal at the moment is within a specified range.

The second power supply module 330 is configured to: receive the second signal output by the signal output module 310; determine whether an absolute value of an amplitude of the second signal is greater than or equal to a specified threshold; if yes, generate a second voltage based on the amplitude of the second signal and output the second voltage to the line driving module 340 through the first input end of the line driving module 340; otherwise, output no signal. An amplitude of the second voltage is greater than the amplitude of the first voltage.

The line driving module 340 is configured to receive the third signal output by the signal output module 310, and perform power amplification on the third signal based on the first voltage output by the first power supply module 320 and the second voltage output by the second power supply module 330.

In the line driving apparatus 300 provided in this embodiment of this application, when an absolute value of an amplitude of a signal output by the signal output module 310 is less than the specified threshold, in other words, when the amplitude of the signal output by the signal output module 310 is relatively small, the second power supply module 330 does not output a signal. In this case, the line driving module 340 amplifies, based on the first voltage output by the first power supply module 320, a signal output by the signal output module 310. In addition, the amplitude of the first voltage at any moment is greater than an amplitude at the moment of a signal output by the signal output module 310; and a difference between the amplitude of the first voltage at any moment and the amplitude at the moment of the signal output by the signal output module 310 is within the specified range. To be specific, when the first voltage changes with the signal output by the signal output module 310 causing the absolute value of the amplitude of the signal output by the signal output module 310 to be less than the specified threshold, a difference between an amplitude of a voltage signal output by the line driving module 340 and the amplitude of the first voltage is relatively small. In other words, the line driver 340 can amplify, by effectively using the first voltage, the signal output by the signal output module 310, thereby reducing heat generated by the line driving module 340 by using the first voltage.

When the absolute value of the amplitude of the signal output by the signal output module 310 is greater than or equal to the specified threshold, in other words, when the amplitude of the signal output by the signal output module 310 is relatively large, the second power supply module 330 outputs the second voltage; and the line driving module 340 amplifies, based on the first voltage and the second voltage, the signal output by the signal output module 310. In this way, when the absolute value of the amplitude of the signal output by the signal output module 310 is greater than or equal to the specified threshold, the first power supply module 320 and the second power supply module 330 can provide the line driving module 340 with voltage signals having relatively large amplitudes, to meet a requirement of the line driving module 340 for amplifying the signal output by the signal output module 310.

A proportion of signals, among signals output by the signal output module in the line driving apparatus 300, whose amplitudes have absolute values greater than or equal to the specified threshold is relatively small, and when the absolute value of the amplitude of the signal output by the signal output module 310 is less than the specified threshold, the difference between the amplitude of the voltage signal output by the line driving module 340 and the amplitude of the first voltage is relatively small. Therefore, the line driving apparatus provided in this application can improve utilization, by the line driving module 340, of the voltages output by the first power supply module 320 and the second power supply module 330, thereby reducing power consumption and heat dissipation costs of the line driving apparatus 300.

During specific implementation, if the line driving apparatus 300 is provided within an xDSL communications device, the signal output module 310 may be a DFE, the signal output module 310may be an AFE, or the signal output module 310 may be integrated with a DFE and an AFE. When the first signal output by the signal output module 310 is a digital signal, the first signal is a signal output by a DFE; or when the first signal is an analog signal, the first signal is a signal output by an AFE. When the second signal output by the signal output module 310 is a digital signal, the second signal is a signal output by a DFE; or when the second signal is an analog signal, the second signal is a signal output by an AFE. When the third signal output by the signal output module 310 is a digital signal, the third signal is a signal output by a DFE; or when the third signal is an analog signal, the third signal is a signal output by an AFE.

If the line driving apparatus 300 is applied to a scenario such as a signal transmission quality test or a device performance test, the signal output module 310 may further be a signal generator.

During specific implementation, the specified range that the difference between the amplitude of the first voltage output by the first power supply module 320 and the amplitude of the first signal output by the signal output module 310 needs to meet may be determined based on an empirical value or a simulation result, so that the difference between the amplitude of the first voltage and the amplitude of the first signal is relatively small. In addition, when an amplitude of the third signal received by the line driving module 340 is less than the specified threshold, the amplitude of the first voltage can meet a requirement of the line driving module 340 for amplifying the third signal.

In a possible implementation, as shown in FIG. 4a, the line driving apparatus 300 may further include a control module 350. A first input end of the control module 350 is connected to the first power supply module 320, a second input end of the control module 350 is connected to the second power supply module 330, and an output end of the control module 350 is connected to the first input end of the line driving module 340. The control module 350 is configured to compare the amplitude of the first voltage output by the signal output module 310 with an amplitude of a voltage output by the second power supply module 330, and output a voltage, with a larger amplitude, of the first voltage and the voltage that is output by the second power supply module 330, where the amplitude of the second voltage output by the second power supply module 330 is greater than the amplitude of the first voltage output by the first power supply module 320.

When an absolute value of the amplitude of the first signal output by the signal output module 310 is less than the specified threshold, the first power supply module 320 outputs the first voltage, the second power supply module 330 does not output a signal, and the control module 350 outputs the first voltage. When the absolute value of the amplitude of the first signal output by the signal output module 310 is greater than or equal to the specified threshold, the first power supply module 320 outputs the first voltage, the second power supply module 330 outputs the second voltage, where the second voltage is greater than the first voltage, and the control module 350 outputs the second voltage. In this way, when the absolute value of the amplitude of the signal output by the signal output module 310 is less than the specified threshold, the line driving module 340 amplifies, based on the first voltage output by the first power supply module 320, the signal output by the signal output module; or when the absolute value of the amplitude of the signal output by the signal output module 310 is greater than or equal to the specified threshold, the line driving module 340 amplifies, based on the second voltage output by the second power supply module 330, the signal output by the signal output module, to further reduce the power consumption of the line driving apparatus 300.

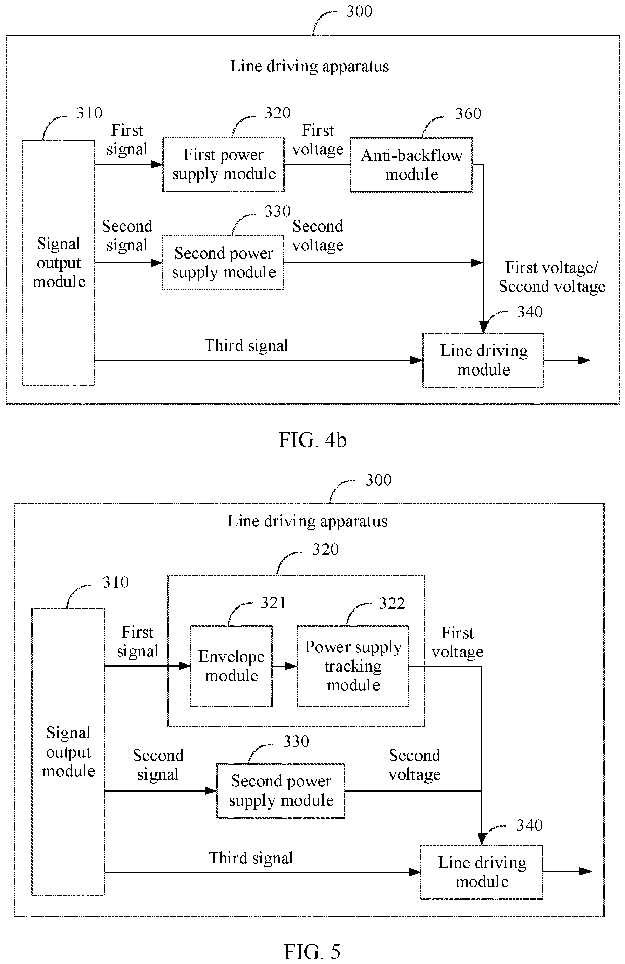

In another possible implementation, as shown in FIG. 4b, the line driving apparatus 300 further includes an anti-backflow module 360, which is separately connected to an output end of the first power supply module 320 and the first input end of the line driving module 340. The anti-backflow module 360 is configured to be conducted when the second signal output by the signal output module 310 is less than the specified threshold, to output, to the first input end of the line driving module 340, the first voltage output by the first power supply module 320; and is configured to be terminated when the second signal output by the signal output module 310 is greater than or equal to the specified threshold, to prevent the second voltage output by the second power supply module 330 from backflowing into the first power supply module 320, so that performance of the first power supply module 320 and the line driving module 340 is not affected. Specifically, the anti-backflow module 360 may be a diode. A positive electrode of the diode is connected to the output end of the first power supply module, and a negative electrode of the diode is connected to the first input end of the line driving module 340.

During specific implementation, after receiving the first signal output by the signal output module 310 and before generating the corresponding first voltage based on the amplitude of the first signal at each moment, the first power supply module 320 may further be configured to: determine whether an absolute value of the amplitude of the first signal is less than the specified threshold; if yes, generate the corresponding first voltage based on the amplitude of the first signal at each moment; otherwise, output no signal. In this way, when the absolute value of the amplitude of the first signal output by the signal output module 310 is less than the specified threshold, the line driving module 340 amplifies, based on the first voltage output by the first power supply module 320, the signal output by the signal output module; or when the absolute value of the amplitude of the signal output by the signal output module 310 is greater than or equal to the specified threshold, the line driving module 340 amplifies, based on the second voltage output by the second power supply module 330, the signal output by the signal output module, to further reduce the power consumption of the line driving apparatus 300.

In a specific implementation, the first power supply module 320 specifically includes an envelope module 321 and a power source tracking module 322. An input end of the envelope module 321 is connected to an output end of the signal output module 310, an output end of the envelope module 321 is connected to an input end of the power source tracking module 322, and an output end of the power source tracking module 322 is connected to the first input end of the line driving module, as shown in FIG. 5.

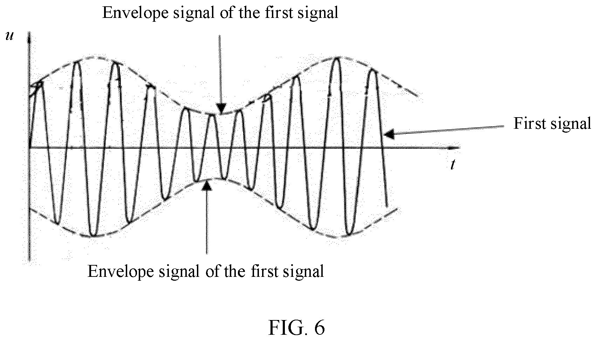

The envelope module 321 is configured to receive the first signal output by the signal output module 310, generate an envelope signal of the first signal based on the first signal, and output the envelope signal of the first signal to the power source tracking module 322. The power source tracking module 322 is configured to receive the envelope signal of the first signal, generate the first voltage based on the envelope signal of the first signal, and output the first voltage through first input end of the line driving module 340. The envelope signal of the first signal is a signal including an extremum in the first signal. Compared with the first signal, the envelope signal of the first signal includes fewer high frequency components. In other words, a change rate of the envelope signal of the first signal is relatively small, so that the first voltage is generated based on the envelope signal of the first signal to adapt to a tracking capability of the power source tracking module 322. For example, the first signal and the envelope signal of the first signal are shown in FIG. 6.

Specifically, to further adapt to the tracking capability of the power source tracking module 322, the envelope module 321 is further configured to perform smooth filtering on the envelope signal of the first signal, to remove some high frequency componentsfrom the envelope signal of the first signal.

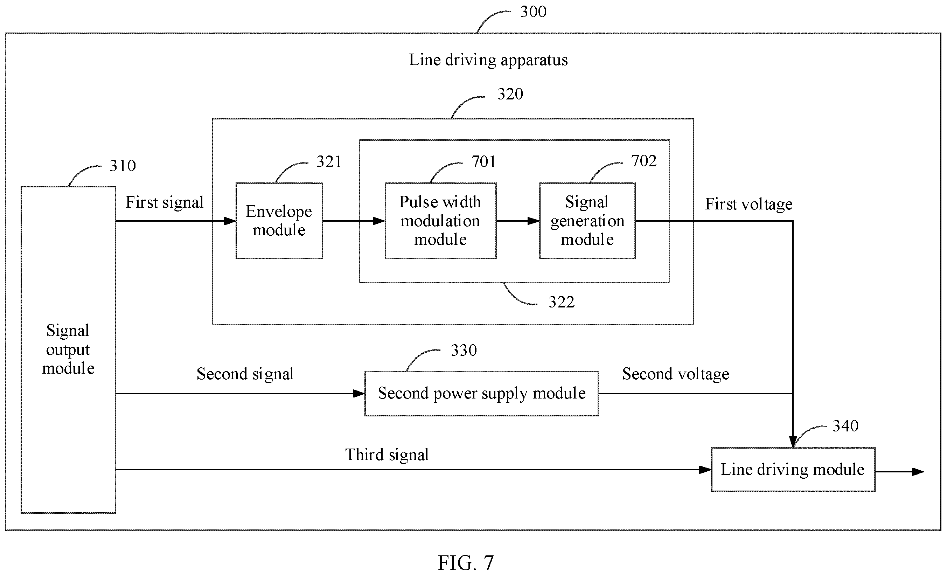

During specific implementation, when the first signal output by the signal output module 310 is a digital signal, the power source tracking module 322 specifically includes a pulse width modulation module 701 and a signal generation module 702. A first input end of the pulse width modulation module 701 is connected to the output end of the envelope module 321, and an output end of the pulse width modulation module 701 is connected to an input end of the signal generation module 702, as shown in FIG. 7.

The pulse width modulation module 701 is configured to receive the envelope signal of the first signal; generate, based on the envelope signal of the first signal, a pulse width modulation signal corresponding to the envelope signal of the first signal; and output the pulse width modulation signal corresponding to the envelope signal of the first signal to the signal generation module 702. In this way, the pulse width modulation module 701 can modulate a pulse width of the first signal in digital domain, so that pulse width modulation is implemented relatively easily, thereby further reducing costs of the line driving module.

The signal generation module 702 is configured to receive the pulse width modulation signal, generate the first voltage based on the pulse width modulation signal, and output the first voltage through the first input end of the line driving module 340.

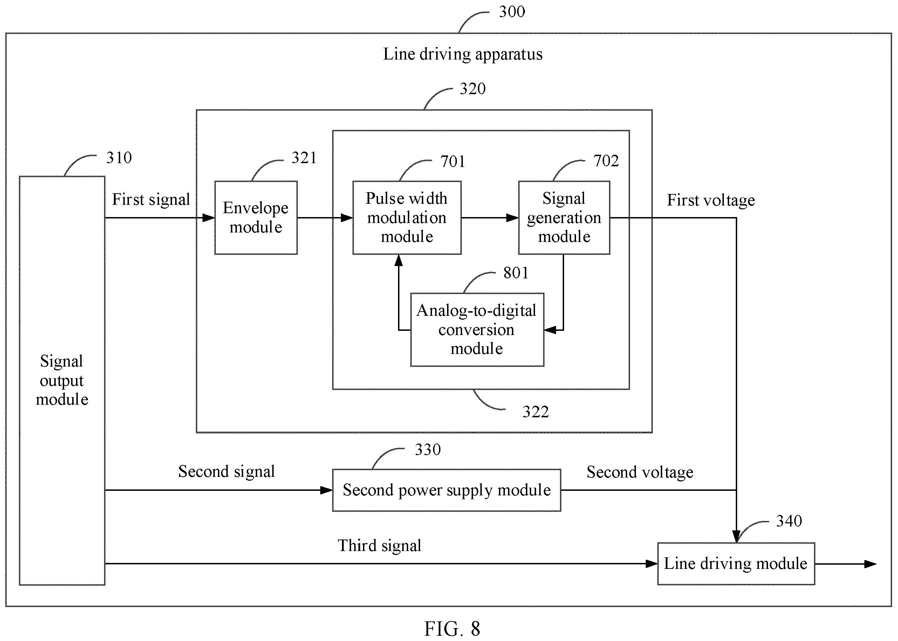

To improve accuracy of the first voltage output by the signal generation module 702, the power source tracking module 322 further includes an analog-to-digital conversion module 801. An input end of the analog-to-digital conversion module 801 is connected to an output end of the signal generation module 702, and an output end of the analog-to-digital conversion module 801 is connected to a second input end of the pulse width modulation module 701, as shown in FIG. 8.

The analog-to-digital conversion module 801 is configured to receive the first voltage, convert the first voltage into a digital signal, and feed back the digital signal of the first voltage to the pulse width modulation module 701. The pulse width modulation module 701 is further configured to receive the digital signal of the first voltage, compare the envelope signal of the first signal with the digital signal of the first voltage output by the analog-to-digital conversion module 801, and adjust the pulse width modulation signal based on a result of the comparison.

In a specific implementation, when adjusting the pulse width modulation signal based on the result of the comparison, the pulse width modulation module 701 is specifically configured to: when an amplitude of the envelope signal of the first signal is greater than an amplitude of the digital signal of the first voltage, increase a duty cycle of the pulse width modulation signal, to increase an amplitude of the first voltage output by the signal generation module 702; or when the amplitude of the envelope signal of the first signal is less than the amplitude of the digital signal of the first voltage, decrease the duty cycle of the pulse width modulation signal, to decrease the amplitude of the first voltage output by the signal generation module 702. In this way, the first voltage can accurately follow a change of the first signal.

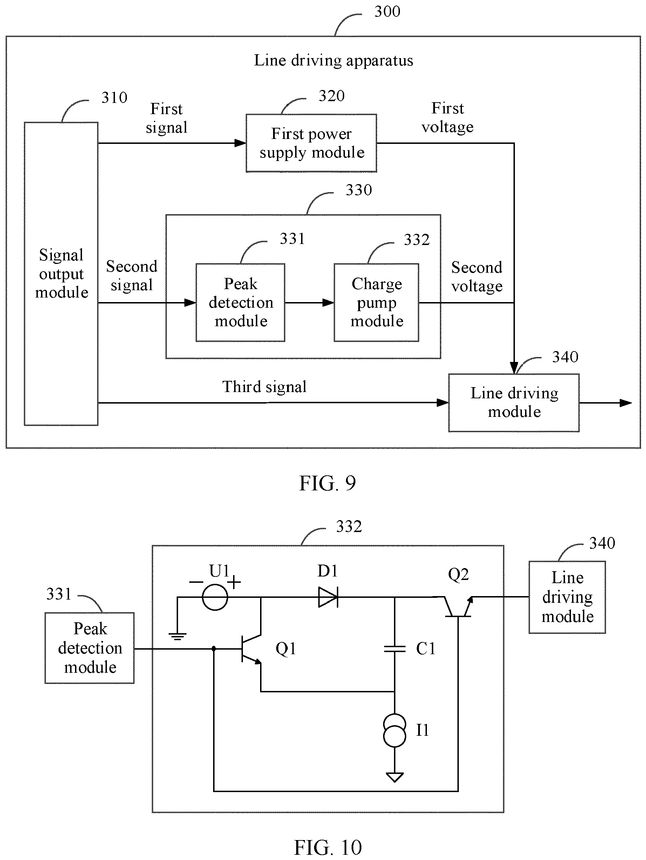

Optionally, as shown in FIG. 9, the second power supply module 330 specifically includes a peak detection module 331 and a charge pump module 332. An input end of the peak detection module 331 is connected to an output end of the signal output module, an output end of the peak detection module 331 is connected to an input end of the charge pump module 332, and an output end of the charge pump module 332 is connected to the first input end of the line driving module.

The peak detection module 331 is configured to: receive the second signal output by the signal output module 310; determine whether the absolute value of the amplitude of the second signal is greater than or equal to the specified threshold; if yes, output a first control signal; otherwise, output a second control signal, where the first control signal is used to control the charge pump module 332 to generate and output the second voltage, and the second control signal is used to control the charge pump module 332 not to output a signal. The charge pump module 332 is configured to: when the absolute value of the amplitude of the second signal is greater than or equal to the specified threshold, receive the first control signal, and generate and output the second voltage based on the first control signal; and when the absolute value of the amplitude of the second signal is less than the specified threshold, receive the second control signal and output no signal.

In a specific implementation, the charge pump module 332 includes a voltage source U1, a first transistor Q1, a second transistor Q2, a diode D1, a capacitor C1, and a current mirror I1, as shown in FIG. 10. A positive electrode of the voltage source U1 is connected to a positive electrode of the diode D1, and a negative electrode of the voltage source U1 is grounded. When the first transistor Q1 is an NPN transistor, a base of the first transistor Q1 is connected to the output end of the peak detection module 331, a collector of the first transistor Q1 is connected to the positive electrode of the diode D1, and an emitter of the first transistor Q1 is connected to the current mirror I1. When the first transistor Q1 is a PNP transistor, a base of the first transistor Q1 is connected to the output end of the peak detection module 331, an emitter of the first transistor Q1 is connected to the positive electrode of the diode D1, and a collector of the first transistor Q1 is connected to the current mirror I1. When the second transistor Q2 is an NPN transistor, a base of the second transistor Q2 is connected to the output end of the peak detection module 331, a collector of the second transistor Q2 is connected to a negative electrode of the diode D1, and an emitter of the second transistor Q2 is connected to the first input end of the line driving module 340. When the second transistor Q2 is a PNP transistor, a base of the second transistor Q2 is connected to the output end of the peak detection module 331, an emitter of the second transistor Q2 is connected to the negative electrode of the diode D1, and a collector of the second transistor Q2 is connected to the first input end of the line driving module 340. The capacitor C1 is separately connected to the negative electrode of the diode D1 and the current mirror I1.

When the peak detection module 331 outputs the first control signal, the first transistor Q1 and the second transistor Q2 are conducted, the diode D1 is terminated, and an output end of the voltage source U1 is connected to a negative electrode of the capacitor C1 through the first transistor Q1. In this case, the voltage source U1 supplies power to the line driving module 340 through the first transistor Q1, the capacitor C1, and the second transistor Q2, and a voltage output by the second transistor Q2 (the second voltage output by the charge pump module 332) is a sum of a voltage of the voltage source U1 and a voltage that is generated through discharging by the capacitor C1. When the peak detection module 331 outputs the second control signal, the first transistor Q1 and the second transistor Q2 are terminated, and the diode D1 is conducted. In this case, the voltage source U1 charges the capacitor C1 through the current mirror I1, and a voltage output by the second transistor Q2 (the second voltage output by the charge pump module 332) is 0.

During specific implementation, to prevent performance of the line driving apparatus 300 from being affected by noise generated because an amplitude of the second voltage output by the charge pump module 332 jumps when the amplitude of the second signal output by the signal output module 310 approximates the specified threshold, after determining that the absolute value of the amplitude of the second signal is less than the specified threshold, the peak detection module 331 is further configured to: determine whether the absolute value of the amplitude of the second signal is greater than a set lower limit; if yes, output a third control signal; otherwise, output the second control signal, where the third control signal is used to control the charge pump module 332 to output a third voltage, and the third voltage is greater than the first voltage and less than the second voltage. The charge pump module 332 is further configured to: when the absolute value of the amplitude of the second signal is greater than the set lower limit and less than the specified threshold, receive the third control signal, and output the third voltage based on the third control signal.

Specifically, when the peak detection module 331 outputs the third control signal, the charge pump module 332 shown in FIG. 10 performs delay processing on the third control signal and then outputs the third control signal to the first transistor Q1, and directly outputs the third control signal to the second transistor Q2. In this way, the charge pump module 332 can first control the second transistor Q2 and the diode D1 to be conducted, and supply power to the line driving module 340 by using the voltage source U1, the diode D1, and the second transistor Q2. In this case, the voltage output by the second transistor Q2 is the voltage of the voltage source U1 (namely, the third voltage). Then the charge pump module 332 controls the first transistor Q1 to be conducted when the absolute value of the amplitude of the second signal is greater than the specified threshold, to supply power to the line driving module 340 through the voltage source U1, the first transistor Q1, the current mirror I1, the capacitor C1, the diode D1, and the second transistor Q2. In this case, the voltage output by the second transistor Q2 is the sum of the voltage of the voltage source U1 and the voltage that is generated through discharging by the capacitor C1.

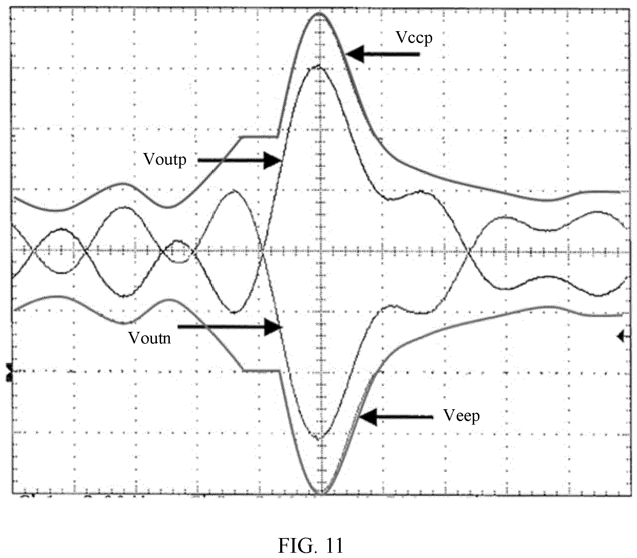

In a scenario in which when the absolute value of the amplitude of the second signal output by the signal output module 310 is greater than the set lower limit and less than the specified threshold, the peak detection module 331 further outputs the third control signal, to control the charge pump module 332 to output the third voltage, differential voltage signals Voutp and Voutn output by the line driving module 340 in the line driving apparatus 300, and a positive voltage Vₑₑₚ and a negative voltage Vₑₑₚ obtained by superimposing the first voltage that is output by the first power supply module 320 and the second voltage that is output by the second power supply module 330 are shown in FIG. 11. It can be learnt from FIG. 11 that when the amplitude of the signal output by the signal output module 310 is relatively small, a difference between the amplitude of the voltage signal output by the line driving module 340 and an amplitude of a signal obtained by superimposing the first voltage and the second voltage is relatively small.

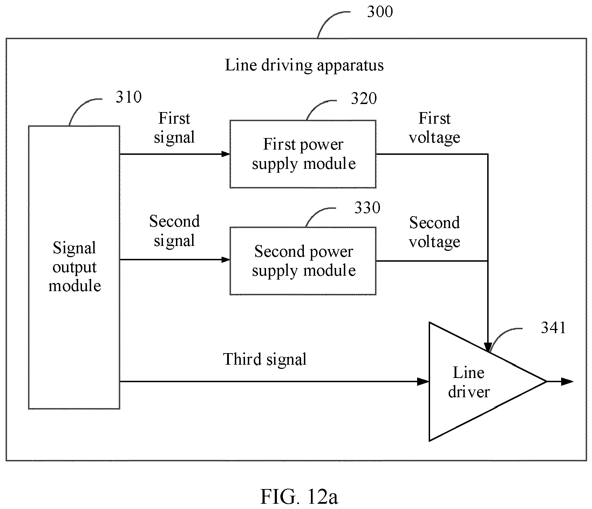

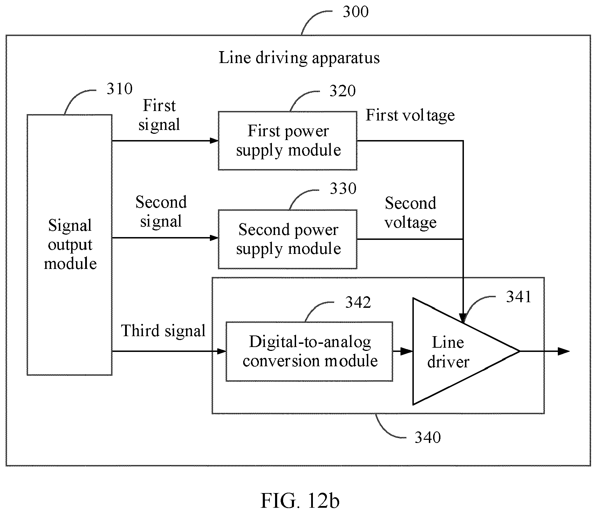

During specific implementation, when the third signal output by the signal output module 310 is an analog signal, the line driving module 340 is a line driver 341, as shown in FIG. 12a. When the third signal is a digital signal, the line driving module 340 includes a line driver 341 and a digital-to-analog conversion module 342. A first input end of the line driver 342 is connected to the first power supply module 320 and the second power supply module 330, an input end of the digital-to-analog conversion module 341 is connected to an output end of the signal output module 310, and an output end of the digital-to-analog conversion module 341 is connected to a second input end of the line driver 342, as shown in FIG. 12b.

The digital-to-analog conversion module 341 is configured to receive the third signal, convert the third signal into an analog signal, and output the analog signal of the third signal to the line driver 342 through the second input end of the line driver 342. The line driver 342 is configured to receive the analog signal of the third signal, and perform power amplification on the analog signal of the third signal based on the first voltage that is output by the first power supply module 320 and the second voltage that is output by the second power supply module 330.

Optionally, the first voltage that is output by the first power supply module 320, the second voltage that is output by the second power supply module 330, and the third signal that is output by the signal output module 310 are synchronous. This prevents distortion of the signal output by the line driving module 340 caused because a voltage obtained by superimposing the first voltage and the second voltage at a specific moment cannot meet a requirement for amplifying the third signal at the moment when the line driving module 340 amplifies the third signal based on the first voltage and the second voltage.

During specific implementation, after receiving the first signal output by the signal output module 310 and before outputting the first voltage, the first power supply module 320 may further be configured to perform delay processing on the first voltage, so that the first voltage that is output by the first power supply module 320, the second voltage that is output by the second power supply module 330, and the third signal that is output by the signal output module 310 are synchronous.

During specific implementation, after receiving the second signal output by the signal output module 310, the second power supply module 330 may further be configured to perform delay processing on the second signal, so that the first voltage that is output by the first power supply module 320, the second voltage that is output by the second power supply module 330, and the third signal that is output by the signal output module 310 are synchronous.

During specific implementation, after receiving the third signal output by the signal output module 310 and before performing power amplification on the third signal based on the first voltage that is output by the first power supply module 320 and the second voltage that is output by the second power supply module 330, the line driving module 340 may further be configured to perform delay processing on the second signal, so that the first voltage that is output by the first power supply module 320, the second voltage that is output by the second power supply module 330, and the third signal that is output by the signal output module 310 are synchronous.

During specific implementation, at least two modules of the first power supply module 320, the second power supply module 330, and the line driving module 340 further include a delay module each. The delay modules are respectively configured to perform delay processing on input signals corresponding to the at least two modules, so that the first voltage that is output by the first power supply module 320, the second voltage that is output by the second power supply module 330, and the third signal that is output by the signal output module 310 are synchronous. The line driving apparatus 300 may implement synchronization between the first voltage, the second voltage, and the third signal by using, including but not limited to, the following four manners.

Manner 1: The first power supply module 320 further includes a first delay module 323, and the second power supply module 330 further includes a second delay module 333. An input end of the first delay module 323 is connected to the output end of the signal output module 310, an output end of the first delay module 323 is connected to the input end of the envelope module 321, and the first delay module 323 is configured to receive the first signal output by the signal output module 310 and perform delay processing on the first signal. Alternatively, the input end of the first delay module 323 is connected to the output end of the envelope module 321, the output end of the first delay module 323 is connected to the input end of the power source tracking module 322, and the first delay module 323 is configured to receive the envelope signal of the first signal output by the envelope module 321 and perform delay processing on the envelope signal of the first signal.

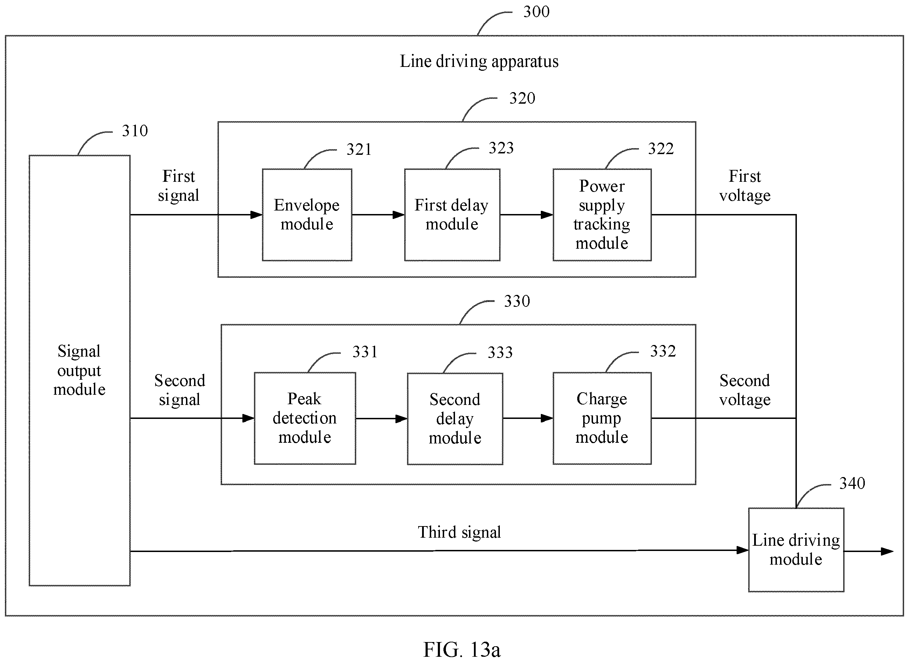

An input end of the second delay module 333 is connected to the output end of the signal output module 310, an output end of the second delay module 333 is connected to the input end of the peak detection module 331, and the second delay module 333 is configured to receive the second signal output by the signal output module 310 and perform delay processing on the second signal. Alternatively, the input end of the second delay module 333 is connected to the output end of the peak detection module 331, the output end of the second delay module 333 is connected to the input end of the charge pump module 332, and the second delay module 333 is configured to receive the first control signal or the second control signal output by the peak detection module 331 and perform delay processing on the first control signal or the second control signal. For example, when the first power supply module 320 further includes the first delay module 323, and the second power supply module 330 further includes the second delay module 333, a structure of the line driving apparatus 300 is shown in FIG. 13a.

Manner 2: The first power supply module 320 further includes a first delay module 323, and the line driving module 340 further includes a third delay module 343. An input end of the first delay module 323 is connected to the output end of the signal output module 310, an output end of the first delay module 323 is connected to the input end of the envelope module 321, and the first delay module 323 is configured to receive the first signal output by the signal output module 310 and perform delay processing on the first signal. Alternatively, the input end of the first delay module 323 is connected to the output end of the envelope module 321, the output end of the first delay module 323 is connected to the input end of the power source tracking module 322, and the first delay module 323 is configured to receive the envelope signal of the first signal output by the envelope module 321 and perform delay processing on the envelope signal of the first signal.

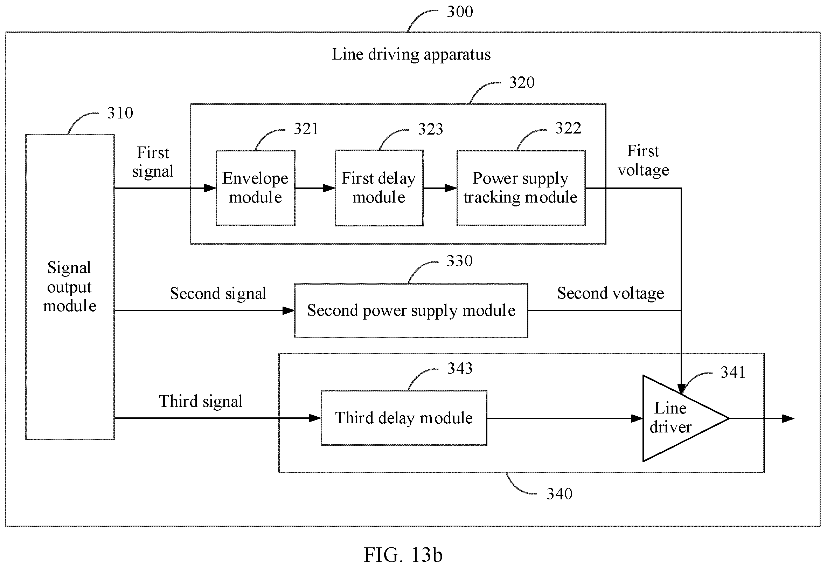

When the third signal output by the signal output module 310 is an analog signal, an input end of the third delay module 343 is connected to the output end of the signal output module 310, an output end of the third delay module 343 is connected to the second input end of the line driver 342, and the third delay module 343 is configured to receive the third signal and perform delay processing on the third signal. When the third signal output by the signal output module 310 is a digital signal, the input end of the third delay module 343 is connected to the output end of the digital-to-analog conversion module 341, the output end of the third delay module 343 is connected to the second input end of the line driver 342, and the third delay module 343 is configured to receive the analog signal of the third signal and perform delay processing on the analog signal of the third signal. Alternatively, the input end of the third delay module 343 is connected to the output end of the signal output module 310, the output end of the third delay module 343 is connected to the input end of the digital-to-analog conversion module 341, and the third delay module 343 is configured to receive the third signal and perform delay processing on the third signal. For example, when the first power supply module 320 further includes the first delay module 323, and the line driving module 340 further includes the third delay module 343, a structure of the line driving apparatus 300 is shown in FIG. 13b.

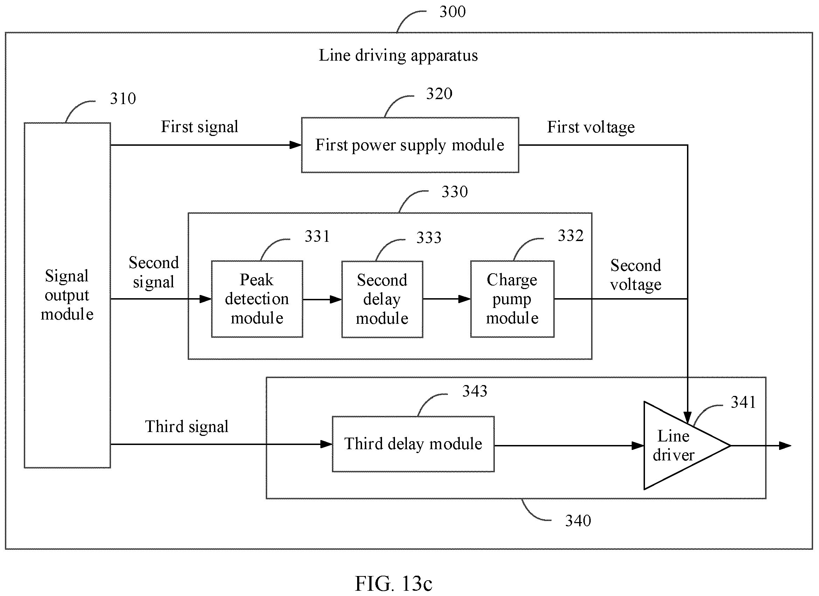

Manner 3: The second power supply module 330 further includes a second delay module 333, and the line driving module 340 further includes a third delay module 343. Connection manners and functions of the second delay module 333 and the third delay module 343 are same as those of the second delay module 333 and the third delay module 343 in manner 1 and implementation 2 above. For details, refer to related descriptions in specific implementation 1 and specific implementation 2. Details are not described herein again. For example, when the second power supply module 330 further includes the second delay module 333, and the line driving module 340 further includes the third delay module 343, a structure of the line driving apparatus 300 is shown in FIG. 13c.

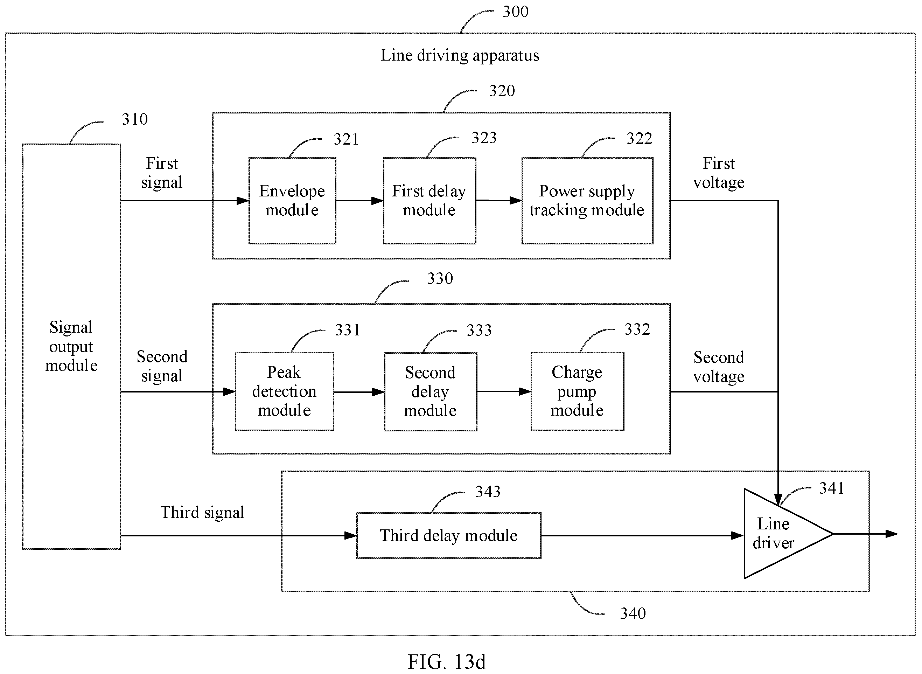

Manner 4: The first power supply module 320 further includes a first delay module 323, the second power supply module 330 further includes a second delay module 333, and the line driving module 340 further includes a third delay module 343. Connection manners and functions of the first delay module 323, the second delay module 333, and the third delay module 343 are same as those of the first delay module 323, the second delay module 333, and the third delay module 343 in manner 1 and manner 2 above. For details, refer to related descriptions in specific implementation 1 and specific implementation 2. Details are not described herein again. For example, when the first power supply module 320 further includes the first delay module 323, the second power supply module 330 further includes the second delay module 333, and the line driving module 340 further includes a third delay module 343, a structure of the line driving apparatus 300 is shown in FIG. 13d.

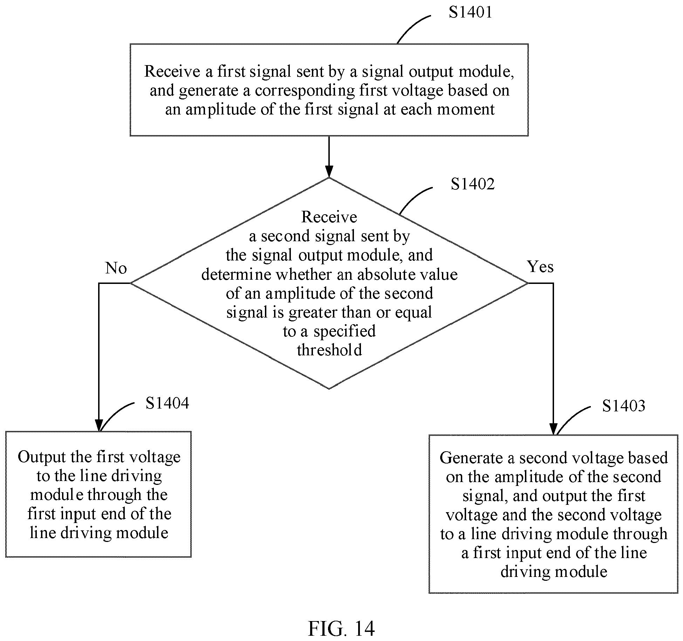

Based on the foregoing embodiments, this application further provides a line driving method. The method can be considered as a method performed by the first power supply module and the second power supply module in the line driving apparatus 300. Referring to FIG. 14, the method includes the following steps.

S1401: Receive a first signal sent by a signal output module, and generate a corresponding first voltage based on an amplitude of the first signal at each moment.

The first signal is a digital signal or an analog signal of a to-be-processed voltage signal, and an amplitude of the first voltage at any moment is greater than an amplitude of the first signal at the moment, and a difference between the amplitude of the first voltage at any moment and the amplitude of the first signal at the moment is within a specified range.

S1402: Receive a second signal sent by the signal output module; determine whether an absolute value of an amplitude of the second signal is greater than or equal to a specified threshold; if yes, perform step S1403; otherwise, perform step S1404, where the second signal is a digital signal or an analog signal of the to-be-processed voltage signal.

It should be noted that a sequence of S1401 and S1402 is not limited in this embodiment of this application. To be specific, S1401 may be performed prior to S1402, S1402 may be performed prior to S1401, or S1401 and S1402 may be performed simultaneously.

S1403: Generate a second voltage based on the amplitude of the second signal, and output the first voltage and the second voltage to a line driving module through a first input end of the line driving module, where an amplitude of the second voltage is greater than the amplitude of the second signal.

S 1404: Output the first voltage to the line driving module through the first input end of the line driving module.

Correspondingly, the line driving module performs power amplification on a third signal based on the first voltage and the second voltage, where the third signal is a digital signal or an analog signal of the to-be-processed voltage signal output by the signal output module through a second input end of the line driving module.

It should be noted that the method shown in FIG. 14 can be considered as a method performed by the first power supply module and the second power supply module in the line driving apparatus 300. For an implementation that is not detailed in the method shown in FIG. 14, refer to related descriptions of the line driving apparatus 300.

In summary, according to the line driving apparatus and method provided in the embodiments of this application, by using the solutions provided in the embodiments of this application, utilization of a power supply voltage by the line driving module can be improved, thereby reducing the power consumption and heat dissipation costs of the line driving apparatus.

A person skilled in the art should understand that the embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, a CD-ROM, an optical memory, and the like) that include computer usable program code.

This application is described with reference to the flowcharts and/or block diagrams of the method, the device (system), and the computer program product according to the embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may be stored in a computer readable memory that can instruct the computer or any other programmable data processing device to work in a specific manner, so that the instructions stored in the computer readable memory generate an artifact that includes an instruction apparatus. The instruction apparatus implements a specific function in one or more processes in the flowcharts and/or in one or more blocks in the block diagrams.

These computer program instructions may be loaded onto a computer or another programmable data processing device, so that a series of operations and steps are performed on the computer or the another programmable device, thereby generating computer-implemented processing. Therefore, the instructions executed on the computer or the another programmable device provide steps for implementing a specific function in one or more processes in the flowcharts and/or in one or more blocks in the block diagrams.

Obviously, persons skilled in the art can make various modifications and variations to the embodiments of this application without departing from the scope of the embodiments of this application. This application is intended to cover these modifications and variations provided that they fall within the scope of protection defined by the following claims.

## Claims

1. Aline driving apparatus (300), comprising: a signal output module (310), a first power supply module (320), a second power supply module (330), and a line driving module (340), wherein
the first power supply module (320) is connected to the signal output module (310) and a first input end of the line driving module (340); the second power supply module (330) is connected to the signal output module (310) and the first input end of the line driving module (340); a second input end of the line driving module (340) is connected to the signal output module (310);
the signal output module (310) is configured to output a first signal to the first power supply (320) module, output a second signal to the second power supply module (330), and output a third signal to the line driving module (340), wherein the first signal is a digital signal or an analog signal of a to-be-processed voltage signal, the second signal is a digital signal or an analog signal of the to-be-processed voltage signal, and the third signal is a digital signal or an analog signal of the to-be-processed voltage signal;
the first power supply module (320) is configured to receive the first signal, generate a corresponding first voltage based on an amplitude of the first signal at each moment, and output the first voltage to the line driving module (340) through the first input end of the line driving module (340), wherein an amplitude of the first voltage at any moment is greater than an amplitude of the first signal at the moment, and a difference between the amplitude of the first voltage at any moment and the amplitude of the first signal at the moment is within a specified range;
the second power supply module (330) is configured to: receive the second signal; determine whether an absolute value of an amplitude of the second signal is greater than or equal to a specified threshold; if the absolute value of the amplitude of the second signal is greater than or equal to the specified threshold, generate a second voltage based on the amplitude of the second signal, and output the second voltage to the line driving module (340) through the first input end of the line driving module (340); and if the absolute value of the amplitude of the second signal is less than the specified threshold, output no signal, wherein an amplitude of the second voltage is greater than the amplitude of the second signal; and
the line driving module (340) is configured to receive the third signal, and perform power amplification on the third signal based on the first voltage and the second voltage.

2. The apparatus (300) according to claim 1, wherein the apparatus (300) further comprises a control module (350), wherein a first input end of the control module (350) is connected to the first power supply module (320), a second input end of the control module (350) is connected to the second power supply module (330), and an output end of the control module (350) is connected to the first input end of the line driving module (340); and
the control module (350) is configured to compare the amplitude of the first voltage with an amplitude of a voltage output by the second power supply module (330), and output a voltage, with a larger amplitude, of the first voltage and the voltage that is output by the second power supply module (330), wherein the amplitude of the second voltage is greater than the amplitude of the first voltage.

3. The apparatus (300) according to claim 1, wherein after receiving the first signal and before generating the corresponding first voltage based on the amplitude of the first signal at each moment, the first power supply module (320) is further configured to:
determine whether an absolute value of the amplitude of the first signal is less than the specified threshold; if the absolute value of the amplitude of the first signal is less than the specified threshold, generate the corresponding first voltage based on the amplitude of the first signal at each moment; and if the absolute value of the amplitude of the first signal is not less than the specified threshold, output no signal.

4. The apparatus (300) according to claim 1 or 2, wherein the first power supply module (320) specifically comprises an envelope module (321) and a power supply tracking module (322), wherein
the envelope module (321) is configured to receive the first signal, generate an envelope signal of the first signal based on the first signal, and output the envelope signal of the first signal to the power supply tracking module (322); and
the power supply tracking module (322) is configured to receive the envelope signal of the first signal, generate the first voltage based on the envelope signal of the first signal, and output the first voltage through the first input end of the line driving module (340).

5. The apparatus (300) according to claim 4, wherein when the first signal is a digital signal, the power supply tracking module (322) specifically comprises a pulse width modulation module (701) and a signal generation module (702), wherein a first input end of the pulse width modulation module (701) is connected to an output end of the envelope module (321), and an output end of the pulse width modulation module (701) is connected to an input end of the signal generation module (702);
the pulse width modulation module (701) is configured to: receive the envelope signal of the first signal; generate, based on the envelope signal of the first signal, a pulse width modulation signal corresponding to the envelope signal; and output the pulse width modulation signal corresponding to the envelope signal to the signal generation module (702); and
the signal generation module (702) is configured to receive the pulse width modulation signal, generate the first voltage based on the pulse width modulation signal, and output the first voltage through the first input end of the line driving module (340).

6. The apparatus (300) according to claim 5, wherein the power supply tracking module (322) further comprises an analog-to-digital conversion module (801), configured to receive the first voltage, convert the first voltage into a digital signal, and feed back the digital signal of the first voltage to the pulse width modulation module (701); and
the pulse width modulation module (701) is further configured to receive the digital signal of the first voltage, compare the envelope signal of the first signal with the digital signal of the first voltage, and adjust the pulse width modulation signal based on a result of the comparison.

7. The apparatus (300) according to any one of claims 1 to 6, wherein the second power supply module (330) specifically comprises a peak detection module (331) and a charge pump module (332), wherein
the peak detection module (331) is configured to: receive the second signal; determine whether the absolute value of the amplitude of the second signal is greater than or equal to the specified threshold; if the absolute value of the amplitude of the second signal is greater than or equal to the specified threshold, output a first control signal; and if the absolute value of the amplitude of the second signal is less than the specified threshold, output a second control signal, wherein the first control signal is used to control the charge pump module (332) to generate and output the second voltage, and the second control signal is used to control the charge pump module (332) not to output a signal; and
the charge pump module (332) is configured to: when the absolute value of the amplitude of the second signal is greater than or equal to the specified threshold, receive the first control signal, and generate and output the second voltage based on the first control signal; and when the absolute value of the amplitude of the second signal is less than the specified threshold, receive the second control signal and output no signal.

8. The apparatus (300) according to any one of claims 1 to 7, wherein when the third signal is an analog signal, the line driving module (340) is a line driver (341).

9. The apparatus (300) according to any one of claims 1 to 7, wherein when the third signal is a digital signal, the line driving module (340) specifically comprises a digital-to-analog conversion module (342) and a line driver (341), wherein a first input end of the line driver (341) is separately connected to the first power supply module (320) and the second power supply module (330), the digital-to-analog conversion module (342) is separately connected to the signal output module (310) and a second input end of the line driver (341);
the digital-to-analog conversion module (342) is configured to receive the third signal, convert the third signal into an analog signal, and output the analog signal of the third signal to the line driver (341) through the second input end of the line driver (341); and
the line driver (341) is configured to receive the analog signal of the third signal, and perform power amplification on the analog signal of the third signal based on the first voltage and the second voltage.

10. The apparatus (300) according to any one of claims 1 to 9, wherein the first voltage, the second voltage, and the third signal are synchronous.

11. The apparatus (300) according to claim 10, wherein after receiving the first signal and before outputting the first voltage, the first power supply module (320) is further configured to perform delay processing on the first voltage.

12. The apparatus (300) according to claim 10 or 11, wherein after receiving the second signal and before outputting the second voltage, the second power supply module (330) is further configured to perform delay processing on the second signal.

13. The apparatus (300) according to any one of claims 10 to 12, wherein after receiving the third signal and before performing power amplification on the third signal based on the first voltage and the second voltage, the line driving module (340) is further configured to perform delay processing on the third signal.

## Patentansprüche

1. Leitungstreibervorrichtung (300), umfassend: ein Signalausgabemodul (310), ein erstes Stromversorgungsmodul (320), ein zweites Stromversorgungsmodul (330) und ein Leitungstreibermodul (340), wobei
das erste Stromversorgungsmodul (320) mit dem Signalausgabemodul (310) und einem ersten Eingangsende des Leitungstreibermoduls (340) verbunden ist; das zweite Stromversorgungsmodul (330) mit dem Signalausgabemodul (310) und dem ersten Eingangsende des Leitungstreibermoduls (340) verbunden ist; ein zweites Eingangsende des Leitungstreibermoduls (340) mit dem Signalausgabemodul (310) verbunden ist;
das Signalausgabemodul (310) zum Ausgeben eines ersten Signals an das erste Stromversorgungsmodul (320), Ausgeben eines zweiten Signals an das zweite Stromversorgungsmodul (330) und Ausgeben eines dritten Signals an das Leitungstreibermodul (340) konfiguriert ist, wobei das erste Signal ein digitales Signal oder ein analoges Signal eines zu verarbeitenden Spannungssignals ist, das zweite Signal ein digitales Signal oder ein analoges Signal des zu verarbeitenden Spannungssignals ist, und das dritte Signal ein digitales Signal oder ein analoges Signal des zu verarbeitenden Spannungssignals ist;
das erste Stromversorgungsmodul (320) zum Empfangen des ersten Signals, Erzeugen einer entsprechenden ersten Spannung basierend auf einer Amplitude des ersten Signals in jedem Moment und Ausgeben der ersten Spannung über das erste Eingangsende des Leitungstreibermoduls (340) an das Leitungstreibermodul (340) konfiguriert ist, wobei eine Amplitude der ersten Spannung in jedem Moment größer als eine Amplitude des ersten Signals in dem Moment ist, und eine Differenz zwischen der Amplitude der ersten Spannung in jedem Moment und der Amplitude des ersten Signals in dem Moment innerhalb eines spezifischen Bereichs liegt;
das zweite Stromversorgungsmodul (330) konfiguriert ist zum: Empfangen des zweiten Signals; Bestimmen, ob ein absoluter Wert einer Amplitude des zweiten Signals größer als oder gleich wie eine spezifizierte Schwelle ist; Erzeugen einer zweiten Spannung basierend auf der Amplitude des zweiten Signals und Ausgeben der zweiten Spannung über das erste Eingangsende des Leitungstreibermoduls (340) an das Leitungstreibermodul (340), falls der absolute Wert der Amplitude des zweiten Signals größer als oder gleich wie die spezifizierte Schwelle ist; und Ausgeben keines Signals, falls der absolute Wert der Amplitude des zweiten Signals kleiner als die spezifizierte Schwelle ist, wobei eine Amplitude der zweiten Spannung größer als die Amplitude des zweiten Signals ist; und
das Leitungstreibermodul (340) zum Empfangen des dritten Signals und Durchführen von Leistungsverstärkung am dritten Signal basierend auf der ersten Spannung und der zweiten Spannung konfiguriert ist.

2. Vorrichtung (300) nach Anspruch 1, wobei die Vorrichtung (300) ferner ein Steuermodul (350) umfasst, wobei ein erstes Eingangsende des Steuermoduls (350) mit dem ersten Stromversorgungsmodul (320) verbunden ist, ein zweites Eingangsende des Steuermoduls (350) mit dem zweiten Stromversorgungsmodul (330) verbunden ist, und ein Ausgangsende des Steuermoduls (350) mit dem ersten Eingangsende des Leitungstreibermoduls (340) verbunden ist; und
das Steuermodul (350) so konfiguriert ist, dass es die Amplitude der ersten Spannung mit einer Amplitude einer Spannung vergleicht, die vom zweiten Stromversorgungsmodul (330) ausgegeben wird, und eine Spannung mit einer größeren Amplitude der ersten Spannung und die Spannung ausgibt, die vom zweiten Stromversorgungsmodul (330) ausgeben wird, wobei die Amplitude der zweiten Spannung größer als die Amplitude der ersten Spannung ist.

3. Vorrichtung (300) nach Anspruch 1, wobei das erste Stromversorgungsmodul (320) nach dem Empfangen des ersten Signals und vor dem Erzeugen der entsprechenden ersten Spannung basierend auf der Amplitude des ersten Signals in jedem Moment ferner konfiguriert ist zum:
Bestimmen, ob ein absoluter Wert der Amplitude des ersten Signals kleiner als die spezifizierte Schwelle ist; Erzeugen der entsprechenden ersten Spannung basierend auf der Amplitude des ersten Signals in jedem Moment, falls der absolute Wert der Amplitude des ersten Signals kleiner als die spezifizierte Schwelle ist; und Ausgeben keines Signals, falls der absolute Wert der Amplitude des ersten Signals nicht kleiner als die spezifizierte Schwelle ist.

4. Vorrichtung (300) nach Anspruch 1 oder 2, wobei das erste Stromversorgungsmodul (320) insbesondere ein Hüllkurvenmodul (321) und ein Stromversorgungsverfolgungsmodul (322) umfasst, wobei
das Hüllkurvenmodul (321) zum Empfangen des ersten Signals, Erzeugen eines Hüllkurvensignals des ersten Signals basierend auf dem ersten Signal und Ausgeben des Hüllkurvensignals des ersten Signals an das Stromversorgungsverfolgungsmodul (322) konfiguriert ist; und
das Stromversorgungsverfolgungsmodul (322) zum Empfangen des Hüllkurvensignals des ersten Signals, Erzeugen der ersten Spannung basierend auf dem Hüllkurvensignal des ersten Signals und Ausgeben der ersten Spannung über das erste Eingangsende des Leitungstreibermoduls (340) konfiguriert ist.

5. Vorrichtung (300) nach Anspruch 4, wobei, wenn das erste Signal ein digitales Signal ist, das Stromversorgungsverfolgungsmodul (322) insbesondere ein Pulsbreitenmodulationsmodul (701) und ein Signalerzeugungsmodul (702) umfasst, wobei ein erstes Eingangsende des Pulsbreitenmodulationsmoduls (701) mit einem Ausgangsende des Hüllkurvenmoduls (321) verbunden ist, und ein Ausgangsende des Pulsbreitenmodulationsmoduls (701) mit einem Eingangsende des Signalerzeugungsmoduls (702) verbunden ist;
das Pulsbreitenmodulationsmodul (701) konfiguriert ist zum: Empfangen des Hüllkurvensignals des ersten Signals; Erzeugen eines Pulsbreitenmodulationssignals, das dem Hüllkurvensignal entspricht, basierend auf dem Hüllkurvensignal des ersten Signals; und Ausgeben des Pulsbreitenmodulationssignals, das dem Hüllkurvensignal entspricht, an das Signalerzeugungsmodul (702); und
das Signalerzeugungsmodul (702) zum Empfangen des Pulsbreitenmodulationssignals, Erzeugen der ersten Spannung basierend auf dem Pulsbreitenmodulationssignal und Ausgeben der ersten Spannung über das erste Eingangsende des Leitungstreibermoduls (340) konfiguriert ist.

6. Vorrichtung (300) nach Anspruch 5, wobei das Stromversorgungsverfolgungsmodul (322) ferner ein Analog-Digital-Umwandlungsmodul (801) umfasst, das zum Empfangen der ersten Spannung, Umwandeln der ersten Spannung in ein digitales Signal und Rückführen des digitalen Signals der ersten Spannung zum Pulsbreitenmodulationsmodul (701) konfiguriert ist; und
das Pulsbreitenmodulationsmodul (701) ferner zum Empfangen des digitalen Signals der ersten Spannung, Vergleichen des Hüllkurvensignals des ersten Signals mit dem digitalen Signal der ersten Spannung und Anpassen des Pulsbreitenmodulationssignals basierend auf einem Ergebnis des Vergleichs konfiguriert ist.

7. Vorrichtung (300) nach einem der Ansprüche 1 bis 6, wobei das zweite Stromversorgungsmodul (330) insbesondere ein Spitzenerfassungsmodul (331) und ein Ladepumpenmodul (332) umfasst, wobei
das Spitzenerfassungsmodul (331) konfiguriert ist zum: Empfangen des zweiten Signals; Bestimmen, ob der absolute Wert der Amplitude des zweiten Signals größer als oder gleich wie die spezifizierte Schwelle ist; Ausgeben eines ersten Steuersignals, falls der absolute Wert der Amplitude des zweiten Signals größer als oder gleich wie die spezifizierte Schwelle ist; und Ausgeben eines zweiten Steuersignals, falls der absolute Wert der Amplitude des zweiten Signals kleiner als die spezifizierte Schwelle ist, wobei das erste Steuersignal zum derartigen Steuern des Ladepumpenmoduls (332) verwendet wird, dass die zweite Spannung erzeugt und ausgegeben wird, und das zweite Steuersignal zum derartigen Steuern des Ladepumpenmoduls (332) verwendet wird, dass kein Signal ausgeben wird; und
das Ladepumpenmodul (332) konfiguriert ist zum: Empfangen des ersten Steuersignals und Erzeugen und Ausgeben der zweiten Spannung basierend auf dem ersten Steuersignal, wenn der absolute Wert der Amplitude des zweiten Signals größer als oder gleich wie die spezifizierte Schwelle ist; und Empfangen des zweiten Steuersignals und Ausgeben keines Signals, wenn der absolute Wert der Amplitude des zweiten Signals kleiner als die spezifizierte Schwelle ist.

8. Vorrichtung (300) nach einem der Ansprüche 1 bis 7, wobei das Leitungstreibermodul (340) ein Leitungstreiber (341) ist, wenn das dritte Signal ein analoges Signal ist.

9. Vorrichtung (300) nach einem der Ansprüche 1 bis 7, wobei, wenn das dritte Signal ein digitales Signal ist, das Leitungstreibermodul (340) insbesondere ein Digital-Analog-Umwandlungsmodul (342) und einen Leitungstreiber (341) umfasst, wobei ein erstes Eingangsende des Leitungstreibers (341) separat mit dem ersten Stromversorgungsmodul (320) und dem zweiten Stromversorgungsmodul (330) verbunden ist, das Digital-Analog-Umwandlungsmodul (342) separat mit dem Signalausgabemodul (310) und dem zweiten Eingangsende des Leitungstreibers (341) verbunden ist;
das Digital-Analog-Umwandlungsmodul (342) zum Empfangen des dritten Signals, Umwandeln des dritten Signals in ein analoges Signal und Ausgeben des analogen Signals des dritten Signals durch das zweite Eingangsende des Leitungstreiber (341) an den Leitungstreiber (341) konfiguriert ist; und
der Leitungstreiber (341) zum Empfangen des analogen Signals des dritten Signals und Durchführen von Leistungsverstärkung am analogen Signal des dritten Signals basierend auf der ersten Spannung und der zweiten Spannung konfiguriert ist.

10. Vorrichtung (300) nach einem der Ansprüche 1 bis 9, wobei die erste Spannung, die zweite Spannung und das dritte Signal synchron sind.

11. Vorrichtung (300) nach Anspruch 10, wobei das erste Stromversorgungsmodul (320) nach dem Empfangen des ersten Signals und vor dem Ausgeben der ersten Spannung ferner zum Durchführen von Verzögerungsverarbeitung an der ersten Spannung konfiguriert ist.

12. Vorrichtung (300) nach Anspruch 10 oder 11, wobei das zweite Stromversorgungsmodul (330) nach dem Empfangen des zweiten Signals und vor dem Ausgeben der zweiten Spannung ferner zum Durchführen von Verzögerungsverarbeitung am zweiten Signal konfiguriert ist.

13. Vorrichtung (300) nach einem der Ansprüche 10 bis 12, wobei das Leitungstreibermodul (340) nach dem Empfangen des dritten Signals und vor dem Durchführen von Leistungsverstärkung am dritten Signal basierend auf der ersten Spannung und der zweiten Spannung ferner zum Durchführen von Verzögerungsverarbeitung am dritten Signal konfiguriert ist.

## Revendications

1. Appareil de pilotage de ligne (300), comprenant : un module de sortie de signal (310), un premier module d'alimentation électrique (320), un second module d'alimentation électrique (330), et un module de pilotage de ligne (340), où :
le premier module d'alimentation électrique (320) est connecté au module de sortie de signal (310) et à une première extrémité d'entrée du module de pilotage de ligne (340) ; le second module d'alimentation électrique (330) est connecté au module de sortie de signal (310) et à la première extrémité d'entrée du module de pilotage de ligne (340) ; une seconde extrémité d'entrée du module de pilotage de ligne (340) est connectée au module de sortie de signal (310) ;
le module de sortie de signal (310) est configuré pour délivrer en sortie un premier signal vers le premier module d'alimentation électrique (320), délivrer en sortie un deuxième signal vers le second module d'alimentation électrique (330), et délivrer en sortie un troisième signal vers le module de pilotage de ligne (340), où le premier signal est un signal numérique ou un signal analogique d'un signal de tension à traiter, le deuxième signal est un signal numérique ou un signal analogique du signal de tension à traiter, et le troisième signal est un signal numérique ou un signal analogique du signal de tension à traiter ;
le premier module d'alimentation électrique (320) est configuré pour recevoir le premier signal, générer une première tension correspondante sur la base d'une amplitude du premier signal à chaque instant, et délivrer en sortie la première tension au module de pilotage de ligne (340) par l'intermédiaire de la première extrémité d'entrée du module de pilotage de ligne (340), où une amplitude de la première tension à tout instant est supérieure à une amplitude du premier signal à l'instant, et une différence entre l'amplitude de la première tension à tout instant et l'amplitude du premier signal à l'instant est comprise dans une plage spécifiée ;
le second module d'alimentation électrique (330) est configuré pour : recevoir le second signal ; déterminer si une valeur absolue d'une amplitude du second signal est supérieure ou égale à un seuil spécifié ; si la valeur absolue de l'amplitude du second signal est supérieure ou égale au seuil spécifié, générer une seconde tension sur la base de l'amplitude du second signal, et délivrer en sortie la seconde tension au module de pilotage de ligne (340) par l'intermédiaire de la première extrémité d'entrée du module de pilotage de ligne (340) ; et, si la valeur absolue de l'amplitude du deuxième signal est inférieure au seuil spécifié, ne délivrer aucun signal, où une amplitude de la seconde tension est supérieure à l'amplitude du second signal ; et
le module de pilotage de ligne (340) est configuré pour recevoir le troisième signal, et effectuer une amplification de puissance sur le troisième signal sur la base de la première tension et de la seconde tension.

2. Appareil (300) selon la revendication 1, dans lequel l'appareil (300) comprend en outre un module de commande (350), où une première extrémité d'entrée du module de commande (350) est connectée au premier module d'alimentation électrique (320), une seconde extrémité d'entrée du module de commande (350) est connectée au second module d'alimentation électrique (330), et une extrémité de sortie du module de commande (350) est connectée à la première extrémité d'entrée du module de pilotage de ligne (340) ; et
le module de commande (350) est configuré pour comparer l'amplitude de la première tension à une amplitude d'une tension délivrée en sortie par le second module d'alimentation électrique (330), et délivrer en sortie une tension, avec une amplitude plus grande, parmi la première tension et la tension qui est délivrée par le second module d'alimentation électrique (330), où l'amplitude de la seconde tension est supérieure à l'amplitude de la première tension.

3. Appareil (300) selon la revendication 1, dans lequel, après avoir reçu le premier signal et avant de générer la première tension correspondante sur la base de l'amplitude du premier signal à chaque instant, le premier module d'alimentation (320) est en outre configuré pour :
déterminer si une valeur absolue de l'amplitude du premier signal est inférieure au seuil spécifié ; si la valeur absolue de l'amplitude du premier signal est inférieure au seuil spécifié, générer la première tension correspondante sur la base de l'amplitude du premier signal à chaque instant ; et, si la valeur absolue de l'amplitude du premier signal n'est pas inférieure au seuil spécifié, ne délivrer aucun signal.

4. Appareil (300) selon la revendication 1 ou la revendication 2, dans lequel le premier module d'alimentation électrique (320) comprend spécifiquement un module d'enveloppe (321) et un module de suivi d'alimentation électrique (322), où :
le module d'enveloppe (321) est configuré pour recevoir le premier signal, générer un signal d'enveloppe du premier signal basé sur le premier signal, et délivrer en sortie le signal d'enveloppe du premier signal vers le module de suivi d'alimentation électrique (322) ; et
le module de suivi d'alimentation électrique (322) est configuré pour recevoir le signal d'enveloppe du premier signal, générer la première tension sur la base du signal d'enveloppe du premier signal, et délivrer en sortie la première tension par la première extrémité d'entrée du module de pilotage de ligne (340).

5. Appareil (300) selon la revendication 4, dans lequel, lorsque le premier signal est un signal numérique, le module de suivi d'alimentation électrique (322) comprend spécifiquement un module de modulation de largeur d'impulsion (701) et un module de génération de signal (702), où une première extrémité d'entrée du module de modulation de largeur d'impulsion (701) est connectée à une extrémité de sortie du module d'enveloppe (321), et une extrémité de sortie du module de modulation de largeur d'impulsion (701) est connectée à une extrémité d'entrée du module de génération de signal (702) ;
le module de modulation de largeur d'impulsion (701) est configuré pour : recevoir le signal d'enveloppe du premier signal ; générer, sur la base du signal d'enveloppe du premier signal, un signal de modulation de largeur d'impulsion correspondant au signal d'enveloppe ; et délivrer en sortie le signal de modulation de largeur d'impulsion correspondant au signal d'enveloppe vers le module de génération de signal (702) ; et le module de génération de signal (702) est configuré pour recevoir le signal de modulation de largeur d'impulsion, générer la première tension sur la base du signal de modulation de largeur d'impulsion, et délivrer en sortie la première tension par la première extrémité d'entrée du module de pilotage de ligne (340).

6. Appareil (300) selon la revendication 5, dans lequel le module de suivi d'alimentation électrique (322) comprend en outre un module de conversion analogique-numérique (801), configuré pour recevoir la première tension, convertir la première tension en un signal numérique, et renvoyer le signal numérique de la première tension au module de modulation de largeur d'impulsion (701) ; et
le module de modulation de largeur d'impulsion (701) est en outre configuré pour recevoir le signal numérique de la première tension, comparer le signal d'enveloppe du premier signal avec le signal numérique de la première tension, et ajuster le signal de modulation de largeur d'impulsion sur la base d'un résultat de la comparaison.

7. Appareil (300) selon l'une quelconque des revendications 1 à 6, dans lequel le second module d'alimentation électrique (330) comprend spécifiquement un module de détection de crête (331) et un module de pompe de charge (332), où :
le module de détection de crête (331) est configuré pour : recevoir le deuxième signal ; déterminer si la valeur absolue de l'amplitude du deuxième signal est supérieure ou égale au seuil spécifié ; si la valeur absolue de l'amplitude du deuxième signal est supérieure ou égale au seuil spécifié, délivrer un premier signal de commande ; et, si la valeur absolue de l'amplitude du deuxième signal est inférieure au seuil spécifié, délivrer en sortie un deuxième signal de commande, où le premier signal de commande est utilisé pour commander le module de pompe de charge (332) pour générer et délivrer en sortie la seconde tension, et le deuxième signal de commande est utilisé pour commander le module de pompe de charge (332) pour ne pas délivrer en sortie un signal ; et
le module de pompe de charge (332) est configuré pour : lorsque la valeur absolue de l'amplitude du deuxième signal est supérieure ou égale au seuil spécifié, recevoir le premier signal de commande, et générer et délivrer en sortie la seconde tension sur la base du premier signal de commande ; et, lorsque la valeur absolue de l'amplitude du deuxième signal est inférieure au seuil spécifié, recevoir le deuxième signal de commande et ne délivrer en sortie aucun signal.

8. Appareil (300) selon l'une quelconque des revendications 1 à 7, dans lequel, lorsque le troisième signal est un signal analogique, le module de pilotage de ligne (340) est un pilote de ligne (341).

9. Appareil (300) selon l'une quelconque des revendications 1 à 7, dans lequel lorsque le troisième signal est un signal numérique, le module de pilotage de ligne (340) comprend spécifiquement un module de conversion numérique-analogique (342) et un pilote de ligne (341), où une première extrémité d'entrée du pilote de ligne (341) est connectée séparément au premier module d'alimentation électrique (320) et au second module d'alimentation électrique (330), le module de conversion numérique-analogique (342) est connecté séparément au module de sortie de signal (310) et à une seconde extrémité d'entrée du pilote de ligne (341) ;
le module de conversion numérique-analogique (342) est configuré pour recevoir le troisième signal, convertir le troisième signal en un signal analogique, et délivrer en sortie le signal analogique du troisième signal au pilote de ligne (341) par l'intermédiaire de la seconde extrémité d'entrée du pilote de ligne (341) ; et
le pilote de ligne (341) est configuré pour recevoir le signal analogique du troisième signal, et effectuer une amplification de puissance sur le signal analogique du troisième signal sur la base de la première tension et de la seconde tension.

10. Appareil (300) selon l'une quelconque des revendications 1 à 9, dans lequel la première tension, la seconde tension et le troisième signal sont synchrones.

11. Appareil (300) selon la revendication 10, dans lequel, après avoir reçu le premier signal et avant de délivrer en sortie la première tension, le premier module d'alimentation (320) est en outre configuré pour effectuer un traitement de retard sur la première tension.

12. Appareil (300) selon la revendication 10 ou la revendication 11, dans lequel, après la réception du deuxième signal et avant la sortie de la seconde tension, le second module d'alimentation (330) est en outre configuré pour effectuer un traitement de retard sur le deuxième signal.

13. Appareil (300) selon l'une quelconque des revendications 10 à 12, dans lequel, après réception du troisième signal et avant d'effectuer une amplification de puissance sur le troisième signal sur la base de la première tension et de la seconde tension, le module de pilotage de ligne (340) est en outre configuré pour effectuer un traitement de retard sur le troisième signal.
